(19) Europäisches Patentamt
European Patent Office
Office européen des brevets

(11) EP 4 611 520 A1

(12) **EUROPEAN PATENT APPLICATION**
published in accordance with Art. 153(4) EPC

(43) Date of publication:
**03.09.2025 Bulletin 2025/36**

(21) Application number: **23882603.6**

(22) Date of filing: **24.10.2023**

(51) International Patent Classification (IPC):
***H10N 30/857** (2023.01)* ***H10N 30/077** (2023.01)*
***H10N 30/20** (2023.01)* ***H10N 30/30** (2023.01)*

(52) Cooperative Patent Classification (CPC):
**H10N 30/077; H10N 30/20; H10N 30/30; H10N 30/857**

(86) International application number:
**PCT/JP2023/038253**

(87) International publication number:
**WO 2024/090398 (02.05.2024 Gazette 2024/18)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **25.10.2022 JP 2022170649**
**12.10.2023 JP 2023177083**

(71) Applicant: **CANON KABUSHIKI KAISHA**
**Tokyo 146-8501 (JP)**

(72) Inventors:
- **SAEKI, Kazuho**
  **Tokyo 146-8501 (JP)**
- **HIRATANI, Takayuki**
  **Tokyo 146-8501 (JP)**
- **WATANABE, Masahiro**
  **Tokyo 146-8501 (JP)**
- **OGAWA, Ryo**
  **Tokyo 146-8501 (JP)**
- **HINO, Tetsuo**
  **Tokyo 146-8501 (JP)**

(74) Representative: **TBK**
**Bavariaring 4-6**
**80336 München (DE)**

(54) **DIELECTRIC, METHOD FOR MANUFACTURING DIELECTRIC, AND TRANSDUCER**

(57) The present invention provides a dielectric having a high dielectric property with low hysteresis loss, and having high flexibility. Provided is a dielectric, said dielectric comprising a polyurethane elastomer and an ionic liquid in the polyurethane elastomer, wherein the polyurethane elastomer has a matrix and a domain which is distributed in the matrix, and the domain includes a specific polyether structure.

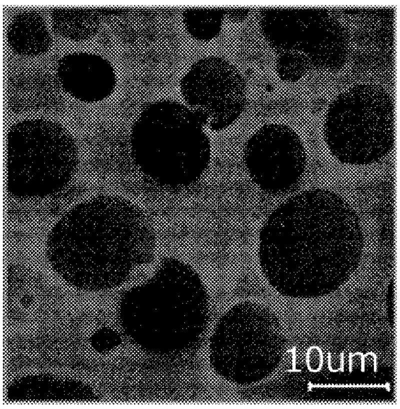


Fig.2



Processed by Luminess, 75001 PARIS (FR)

## Description

### TECHNICAL FIELD

The present disclosure is directed to a dielectric, a method for manufacturing the dielectric, and a transducer.

### BACKGROUND ART

Transducers comprising a dielectric and at least two electrodes with the dielectric inserted therebetween are elements that convert between electrical energy and mechanical energy with high conversion efficiency using deformation (expanding and shrinking) of the dielectric and are being used in various fields. For example, when the electrical energy generated by deformation of the dielectric due to an external force is obtained as an output, the transducer can be used as a sensor or a power generating element. In addition, the transducer can function as an actuator by generating stress in the dielectric by applying a potential difference between the pair of electrodes.

When the dielectric is used in such driving applications, sensor applications and power generation applications, the following properties are important. That is, it is preferable that the dielectric have a high dielectric constant in order to increase the conversion efficiency, have flexibility in consideration of ease of deformation, and have low hysteresis loss properties in order to reduce energy loss due to deformation cycles.

For example, Patent Literature 1 discloses a dielectric sensor using an elastomer composition comprising a polyolefin polyol as a dielectric. In addition,

Patent Literature 2 discloses a dielectric that achieves a high dielectric constant by predominantly distributing an ionic liquid in a microlayer-separated structure using a block polymer and forming high-dielectric-constant layers and low-dielectric-constant layers on the nano-order according to the shape of the microphase-separated structure.

### CITATION LIST

### PATENT LITERATURE

Patent Literature 1 Japanese Patent Application Publication No. 2022-069960
Patent Literature 2 Japanese Patent Application Publication No. 2021-034207

### NON-PATENT LITERATURE

Non Patent Literature 1 Sustainability 2021, 13(17), 9881
Non Patent Literature 2 L.K. Huang and M.J.J. Wang. Image thresholding by minimizing the measures of fuzziness. Pattern recognition, 28(1):41-51, 1995.1, 2.1
Non Patent Literature 3 IEEE Transactions on SYSTEMS, MAN, AND CYBERNETICS, Vol. SMC-9, No. 1, January 1979, pp. 62-66

### SUMMARY OF INVENTION

### TECHNICAL PROBLEM

However, the dielectric disclosed in Patent Literature 1 has flexibility, but it tends to have high hysteresis loss and large energy loss due to deformation. In addition, it is difficult to achieve excellent flexibility with the block polymer comprising a styrene-based polymer and an acrylic acid ester-based polymer disclosed in Patent Literature 2.

Thus, it has been difficult to achieve all the properties required when the dielectric is used as a transducer.

At least one aspect of the present disclosure is directed to provide a dielectric having a high dielectric constant, low hysteresis loss, and high flexibility. In addition, at least one aspect of the present disclosure is directed to provide a method for manufacturing the dielectric. In addition, at least one aspect of the present disclosure is directed to provide a transducer comprising the dielectric.

SOLUTION TO PROBLEM

According to at least one aspect of the present disclosure, there is provided a dielectric,

wherein the dielectric comprises a polyurethane elastomer and an ionic liquid in the polyurethane elastomer,
the polyurethane elastomer comprises a matrix and a domain dispersed in the matrix, and
the domain comprises a first structure represented by following Formula (1):

[C1]

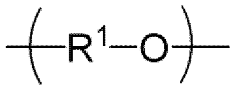

(1)

in Formula (1), $R^1$ represents an alkylene group having 3 to 6 carbon atoms.

Additionally, according to another embodiment of the present disclosure, there is provided a method for manufacturing the above-mentioned dielectric, comprising:

(i) a step of obtaining a second urethane prepolymer having at least two hydroxyl groups by reacting a first urethane prepolymer having at least one isocyanate group with a first polycarbonate polyol having at least two hydroxyl groups;
(ii) a step of obtaining a first dispersion by dispersing droplets comprising at least a part of the second urethane prepolymer in a second polycarbonate polyol;
(iii) a step of obtaining a second dispersion by dispersing the ionic liquid in the first dispersion; and
(iv) a step of preparing a dielectric forming mixture comprising the second dispersion and a polyisocyanate having at least two isocyanate groups, and then reacting the second urethane prepolymer, the second polycarbonate polyol, and the polyisocyanate in the dielectric forming mixture to form the dielectric.

Furthermore, according to another embodiment of the present disclosure, there is provided a transducer using the above-mentioned dielectric, comprising at least two electrodes, and the above-mentioned dielectric inserted between the electrodes.

ADVANTAGEOUS EFFECTS OF INVENTION

According to at least one aspect of the present disclosure, it is possible to obtain a dielectric having excellent dielectric properties, low hysteresis loss, and high flexibility. In addition, according to at least one aspect of the present disclosure, it is possible to obtain a method for manufacturing the above-mentioned dielectric. Furthermore, according to at least one aspect of the present disclosure, it is possible to obtain a transducer comprising the above-mentioned dielectric.

BRIEF DESCRIPTION OF DRAWINGS

[Fig. 1] The schematic diagram showing a method for manufacturing a dielectric according to the present disclosure
[Fig. 2] The photograph (photograph substituting for drawing) showing the distribution of an ionic liquid in a cross section of a dielectric manufactured in Example 1 by using time-of-flight secondary ion mass spectrometry (TOF-SIMS)
[Fig. 3] The graph showing a temperature-loss tangent (tanδ) curve obtained by dynamic mechanical analysis (DMA) of dielectrics manufactured in Example 1 and Comparative Example 1
[Fig. 4] The schematic diagram of a transducer according to one aspect of the present disclosure

DESCRIPTION OF EMBODIMENT

In the present disclosure, the expression of "from XX to YY" or "XX to YY" indicating a numerical range means a numerical range including a lower limit and an upper limit which are end points, unless otherwise specified. When a numerical range is described in a stepwise manner, the upper and lower limits of each numerical range can be arbitrarily combined. In the present disclosure, for example, descriptions such as "at least one selected from the group consisting of

XX, YY and ZZ" mean any of XX, YY, ZZ, the combination of XX and YY, the combination of XX and ZZ, the combination of YY and ZZ, and the combination of XX, YY, and ZZ.

Hereinafter, embodiments of the present disclosure will be described. Here, the embodiments to be described below are only examples, and the present disclosure is not limited to these embodiments.

<Polyurethane Elastomer>

A polyurethane elastomer comprises a matrix and a domain dispersed in the matrix. The domain comprises a first structure (polyether structure) represented by the following Formula (1).

[C2]

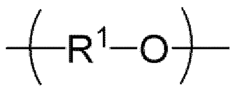

(1)

In Formula (1), $R^1$ represents an alkylene group having 3 to 6 carbon atoms.

Generally, a polyurethane obtained by reacting a polyol having a polyether structure (polyether polyol) with a polyisocyanate has a weak intermolecular force between ether groups. Due to this, since the hardness can be kept very low, it is suitable to impart flexibility to the polyurethane elastomer. On the other hand, the mobility of an ionic liquid to be described below is high due to the weak intermolecular force, and dielectric breakdown easily occurs due to the occurrence of a phenomenon in which ionic charges are locally concentrated when an electric field is applied (accumulation of space charges).

The domain preferably comprises at least one polyether structure represented by Formula (1) and more preferably comprises a plurality of polyether structures. When the domain comprises a plurality of polyether structures represented by Formula (1), the polyether structures may be repeating structural units.

The matrix is not particularly limited as long as it is phase-separated from the domain comprising a first structure. As will be described below, in order to achieve both flexibility and low hysteresis loss, it is preferable that the phase separation between the matrix and the domain be clear. That is, the matrix preferably has low compatibility with the polyether structure comprised in the domain, and preferably comprises a second structure (polycarbonate structure) represented by the following Formula (2).

[C3]

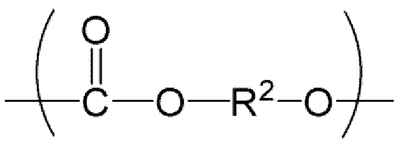

(2)

In Formula (2), $R^2$ represents an alkylene group having 3 to 12 carbon atoms.

Generally, a polyurethane obtained by reacting a polyol (polycarbonate polyol) comprising a polycarbonate structure with a polyisocyanate has a strong intermolecular force between carbonate groups. Due to this, the mobility of the ionic liquid to be described below is low, the space charges are unlikely to accumulate, and thus the polyurethane has excellent resistance to dielectric breakdown. In addition, due to the strong intermolecular force, the polyurethane exhibits mechanical properties such as favorable friction properties and high wear resistance.

The matrix comprises at least one polycarbonate structure represented by Formula (2) and preferably comprises a plurality of polycarbonate structures. When the matrix comprises a plurality of polycarbonate structures represented by Formula (2), the polycarbonate structures may be repeating structural units.

As long as the polyurethane elastomer forms a matrix-domain structure, at least a part of the outer surface of the dielectric may be formed of the matrix. For example, the entire outer surface of the dielectric may be formed of the matrix.

The polyurethane elastomer according to the present disclosure has a domain-matrix structure comprising a domain and a matrix. Thus, the domain comprises a first structure. The inventors found that, when the polyurethane elastomer has such a structure, it is possible to achieve both excellent flexibility and low hysteresis loss.

The reason for this is thought to be that, since the entire domain functions as a soft crosslinking point due to the effect of entropy elasticity, the polyurethane elastomer exhibits excellent elasticity (entropy elasticity) without plastic deformation due to an external force such as compression. As a result, it is thought that it is possible to achieve both excellent flexibility and low hysteresis loss.

In addition, in order to fully utilize flexibility derived from the domain, it is preferable that the phase separation between the domain and the matrix be clear. In addition, it is preferable that the matrix and the domain be chemically linked at the interface by a urethane bond. It is particularly preferable that the matrix comprise a second structure comprising a polycarbonate structure represented by Formula (2). In this case, it is possible to achieve both flexibility and low hysteresis loss to a higher level.

In addition, since the polyurethane elastomer according to the present disclosure has a domain-matrix structure, it is possible to assign different functions to the matrix and the domain. As an example, when the matrix comprises a second structure comprising a polycarbonate structure represented by Formula (2), it is possible to impart resistance to dielectric breakdown, wear resistance and low friction properties in addition to flexibility and low hysteresis loss.

More surprisingly, the inventors found that, when a polyurethane elastomer-comprising dielectric comprises an ionic liquid, it also exhibits a high dielectric constant. A mechanism by which this occurs is unclear, but is thought to be as follows. That is, the polyether structure derived from the polyether polyol comprised in the polyurethane elastomer captures and stabilizes cations of the ionic liquid, and thus the interaction between ion pairs decreases. This increases the average distance between ion pairs, which is thought to increase the relaxation component based on the orientation polarization of dipoles.

In addition, in a temperature-loss tangent (tan$\delta$) curve obtained by dynamic mechanical analysis (DMA) of the dielectric, it is preferable that there be at least two or more peaks due to glass transition observed in a temperature range of -80 to +20°C and it is particularly preferable that there be at least two or more peaks due to glass transition observed in a temperature range of -70 to 0°C.

This indicates that the polyurethane segments comprising a polyether structure and the polyurethane segments that form a matrix are clearly phase-separated via the interface between the matrix and the domain.

As described above, in order to impart resistance to dielectric breakdown, wear resistance and low friction properties to the polyurethane elastomer, it is preferable that the matrix comprise a second structure as a polycarbonate structure represented by Formula (2). In this case, in the temperature-tan$\delta$ curve obtained by DMA of the dielectric, at least one of peaks due to glass transition is observed in a temperature range of -50°C or lower (preferably -80 to -50°C), preferably, at least one of peaks is in a temperature range of -40°C or higher (preferably -40 to 20°C), more preferably, at least one of peaks is in a temperature range of -60°C or lower (more preferably -70 to -60°C), and at least one of peaks is in a temperature range of -35°C or higher (more preferably - 35 to -10°C).

Generally, a peak due to glass transition of polyether is observed in a temperature range of -80°C to -50°C or lower. In addition, a peak due to glass transition of polycarbonate is observed in a temperature range of -40°C to +20°C or lower. Therefore, the presence of peaks due to glass transition in the two temperature ranges indicates that the segments composed of the first structure and the segments composed of the second structure are phase-separated, and the two segments exist with almost no compatibility with each other.

Such clear phase separation prevents the segments composed of the first structure from being mixed into the matrix. As a result of this, when the polyurethane elastomer comprises a second structure comprising a polycarbonate structure as a matrix, it is possible to achieve both flexibility and low hysteresis loss to a higher level. In addition, it is possible to achieve resistance to dielectric breakdown, favorable friction properties, and high wear resistance.

The first structure comprised in the domain of the dielectric and comprising a polyether structure represented by Formula (1) will be described. In the first structure comprised in the domain and represented by Formula (1), $R^1$ represents an alkylene group having 3 to 6 carbon atoms. $R^1$ represents preferably an alkylene group having a branched structure with 3 to 5 carbon atoms, and more preferably an alkylene group having a branched structure with 3 to 4 carbon atoms.

By $R^1$ being an alkylene group having 3 to 6 carbon atoms, the flexibility of polymer chains and the density of ether groups are optimized, and the effect of stabilizing cations derived from the ionic liquid to be described below is secured. In addition, it is more preferable that $R^1$ comprise an alkylene group having a branched structure with 3 to 5 carbon atoms, from the viewpoint that the intermolecular force between ether groups can be kept low and low hardness can be achieved.

Examples of $R^1$'s include $-(CH_2)_m-$ (m=3 to 6 (preferably 3 to 5, and more preferably 3 to 4)), $-CH_2CH(CH_3)-$, $-CH_2C(CH_3)_2CH_2-$, $-CH_2CH(CH_3)CH_2-$, $-(CH_2)_2CH(CH_3)CH_2-$, and $-(CH_2)_2CH(CH_3)(CH_2)_2-$. In the polyurethane elastomer, all $R^1$'s may be the same, or a combination of different $R^1$'s may be used.

The number average molecular weight (Mn) of the polyether structure represented by Formula (1) as a repeating unit in the polyurethane elastomer is preferably from 1,000 to 50,000. The number average molecular weight is based on the raw material polyether polyol. The number average molecular weight (Mn) of the polyether structure represented by Formula (1) is more preferably from 1,200 to 30,000.

When the number average molecular weight is 1,000 or more, the segments comprising a polyether structure easily form a domain. In addition, when the number average molecular weight is 50,000 or less, the phase separation structure can be better stabilized.

The second structure comprising a polycarbonate structure represented by Formula (2), which is disclosed as an example of the matrix of the dielectric will be described. In Formula (2), $R^2$ represents an alkylene group having 3 to 12 carbon atoms. $R^2$ represents preferably an alkylene group having 3 to 9 carbon atoms, and more preferably an alkylene

group having 3 to 6 carbon atoms.

By $R^2$ being an alkylene group having 3 to 12 carbon atoms, low compatibility with the segments comprising a polyether structure represented by Formula (1) is secured, and the phase separation between the matrix and the domain can be made clearer. In addition, it is more preferable that $R^2$ comprise an alkylene group having 3 to 12 carbon atoms, from the viewpoint that the intermolecular force between carbonate groups is appropriately reduced and it is possible to achieve favorable friction properties, as well as high wear resistance and low hardness.

Examples of $R^2$'s include $-(CH_2)_m-$ (m is an integer of 3 to 12, m is preferably an integer of 3 to 9, and m is more preferably an integer of 5 to 7), $-CH_2C(CH_3)_2CH_2-$, $-CH_2CH(CH_3)CH_2-$, and $-(CH_2)_2CH(CH_3)(CH_2)_2-$. In the polyurethane elastomer, all $R^2$'s may be the same or a combination of different $R^2$'s may be used.

The number average molecular weight (Mn) of the polycarbonate structure represented by Formula (2) as a repeating unit in the polyurethane elastomer is preferably from 500 to 10,000. The number average molecular weight is based on the raw material polycarbonate polyol. The number average molecular weight (Mn) of the polycarbonate structure represented by Formula (2) is more preferably from 700 to 8,000. When the number average molecular weight is 500 or more, low compatibility with the polyurethane segments comprising a polyether structure represented by Formula (1) is secured, and the phase separation between the matrix and the domain becomes clearer. In addition, when the number average molecular weight is 10,000 or less, an increase in viscosity of the polycarbonate polyol as a raw material can be reduced.

The number average molecular weight of the polycarbonate structure and the number average molecular weight of polyols to be described below are both values calculated using standard polystyrene molecular weight conversion or the hydroxyl value (mg KOH/g) and the valence.

The number average molecular weight in terms of polystyrene molecular weight can be measured using high performance liquid chromatography. Measurement can be performed using a high-speed GPC device ("HLC-8220GPC," commercially available from Tosoh Corporation) with two columns (Shodex GPCLF-804, molecular weight exclusion limit: $2\times10^6$, separation range: 300 to $2\times10^6$) in series.

When the hydroxyl value and the valence are used, the number average molecular weight can be calculated by the following formula. For example, the number average molecular weight of a polyol with a hydroxyl value of 56.1 mg KOH/g and a valence of 2 can be calculated as 2,000.

$$\text{Number average molecular weight} = 56.1 \times 1{,}000 \times \text{valence} \div \text{hydroxyl value}$$

The area ratio of the matrix to the domain (matrix/domain) observed in a 50 μm×50 μm observation region in a cross section in which the domain and the matrix of the dielectric are exposed is preferably 40.0/60.0 to 90.0/10.0, and the area ratio is more preferably 50.0/50.0 to 85.0/15.0, and still more preferably 55.0/45.0 to 80.0/20.0. When the area ratio of matrix/domain is within the above range, the phase separation form becomes more stable, and the matrix and the domain are more likely to be formed stably.

The area ratio can be controlled by the amount of the domain material and matrix material used.

The arithmetic average value (average diameter) of the equivalent circle diameters of the domain observed in a cross section in which the domain and the matrix are exposed is preferably 0.2 to 30.0 μm, and the equivalent circle diameter is more preferably 0.5 to 20.0 μm and still more preferably 5.0 to 15.0 μm. When the average diameter is 0.2 μm or more, the hardness can be more easily reduced, and when the average diameter is 30.0 μm or less, the phase separation form becomes more stable.

The equivalent circle diameter of the domain can be controlled, for example, by changing the isocyanate index in the step of obtaining a first urethane prepolymer to be described below. Specifically, the equivalent circle diameter can be increased by decreasing the isocyanate index, and the equivalent circle diameter can be decreased by increasing the isocyanate index. In addition, the equivalent circle diameter of the domain can also be controlled by the material and molecular weight of the domain used and a shear force applied when the matrix material is mixed.

In addition, when observation is performed in three observation regions with a 50 μm square in a cross section of the dielectric, the proportion of the number of domains with a circularity of 0.60 to 0.95 based on the total number of domains is preferably 70% by number or more, more preferably 80 to 99% by number, and still more preferably 85 to 95% by number.

In the case of domains having a circularity within the above range, when the domains recover from deformation, anisotropy is unlikely to occur in a direction in which the domain shape recovers. Thus, when the number (proportion) of domains having a circularity within the above range increases, the recovery from deformation is less likely to be anisotropic. In other words, a dielectric can be made to recover from deformation more isotropically. As a result, wrinkles, strains and the like due to anisotropy in the recovery from deformation are unlikely to occur after recovery from deformation.

The number proportion can be adjusted, for example, by the speed at which the material is injected into the mold. When the injection speed is low, the shear force applied to the material is also reduced, and thermal curing can be performed while maintaining a high circularity.

Here, the area ratio of matrix/domain, and the average diameter and circularity of the domain are calculated from a cross-section image of the dielectric obtained using a scanning electron microscope. Details will be described below.

In addition, in the dielectric, the elastic modulus of the domain comprising a first structure is preferably designed to be lower than the elastic modulus of the matrix. Specifically, the parameter indicating the viscoelasticity term of the domain is defined as a parameter A, and the parameter indicating the viscoelasticity term of the matrix is defined as a parameter B, which are measured in a viscoelastic image of a cross section in which the domain and the matrix are exposed under a scanning probe microscope. In this case, it is preferable that the parameters A and B satisfy A<B.

The difference in the relative elastic modulus between the matrix and the domain of the dielectric can be measured by observing a thinned dielectric under a scanning probe microscope (SPM/AFM). As the scanning probe microscope, "S-Image" (product name, commercially available from Hitachi High-Tech Science Corporation) can be used.

In addition, examples of devices for thin sectioning include a sharp razor, a microtome, and a focused ion beam (FIB) device. Among the above devices, an ultramicrotome capable of preparing ultrathin sections can be particularly suitably used. A total of three sections are prepared, arbitrary observation regions of 50 $\mu$m squares are selected, and viscoelastic images are observed in a total of three observation regions.

The measurement mode for the viscoelastic image taken by SPM is a micro viscoelastic dynamic force mode (Viscoelastic Dynamic Force Mode (VE-DFM)). In addition, as the cantilever, a silicon microcantilever for DFM ("SI-DF3" (product name), commercially available from Hitachi High-Tech Science Corporation, spring constant=1.9 N/m) is used. In addition, the scanning frequency is 0.5 Hz.

Here, VE-DFM (microviscoelastic DFM) is a mode in which an image of the surface shape is obtained while controlling the distance between the probe and the measurement sample so that the vibration amplitude of the cantilever is constant while the cantilever is resonating, and at the same time, the viscoelasticity distribution is measured. In VE-DFM, the viscoelasticity distribution is imaged from the deflection amplitude of the cantilever when a periodic force is applied by micro-vibrating the sample in the Z direction. When the sample is hard, the sample deformation is small, and the cantilever amplitude is large, and when the sample is soft, the sample deformation vibration is induced, and the cantilever amplitude is small.

The obtained amplitude is converted into displacement in mV, which becomes the parameter indicating the viscoelasticity term. Therefore, the parameter A and the parameter B are indexes indicating the relationship between the hardness of the domain and the hardness of the matrix present in one observation sample. Here, in VF-DFM, the magnitude of the amplitude of the cantilever is output as a voltage, the units of the parameter A and the parameter B are mV. In addition, a larger value indicates higher elasticity.

After the viscoelastic image is obtained, in each observation region, the parameters indicating the viscoelasticity term are obtained for 10 points each for the matrix and the domain, and their arithmetic average values are taken as the parameter A indicating the viscoelasticity term of the domain and as the parameter B indicating the viscoelasticity term of the matrix. The measurement procedure will be described below.

The value ratio (A/B) of the parameter A to the parameter B is preferably 0.65 or less, more preferably 0.05 to 0.50, still more preferably 0.05 to 0.40, yet more preferably 0.10 to 0.30, and particularly preferably 0.12 to 0.20. When the A/B is smaller, since the difference in viscoelasticity between the matrix and the domain is larger, it becomes easier to achieve both flexibility and low hysteresis loss.

As a method for increasing the difference in viscoelasticity, it is effective to increase the clarity of phase separation between the domain and the matrix, and as described above, it is preferable that the matrix comprise a second structure comprising a polycarbonate structure represented by Formula (2). In addition, as will be described below, in a dielectric manufacturing step, the use of a manufacturing step in which a polyol used as a matrix and a polyether polyol used as a domain are reacted in advance to form a urethane prepolymer is also effective as a method for increasing the clarity of phase separation, that is, increasing the difference in viscoelasticity.

The parameters A and B can be adjusted, for example, by the elastic modulus of the domain and the matrix. The elastic modulus of the matrix can be increased by, for example, increasing the crosslink density of the matrix using a polyisocyanate trimeric compound or polymeric compound as a matrix-forming raw material. Regarding the elastic modulus of the domain, for example, by increasing the molecular weight of the polyether polyol as a domain-forming raw material, the crosslink density of the domain decreases, and the elastic modulus decreases.

In addition, the chemical structures of components comprised in the matrix and the domain can be analyzed using, for example, a spectroscopic analysis device such as an AFM infrared spectroscopic analysis device, a microscopic infrared spectroscopic analysis device, or a microscopic Raman spectroscopic analysis device, or a mass spectrometer.

<Ionic Liquid>

The ionic liquid is a liquid comprising a cationic component and an anionic component, and is a salt that exists as a liquid in a wide temperature range. Examples thereof include a salt having a melting point of 100°C or lower obtained using relatively large organic ions as the ion species that form the salt. The ionic liquid has a function of improving dielectric properties of the polyurethane elastomer.

The cationic component is not particularly limited, and may be, for example, at least one selected from the group consisting of imidazolium ions, pyridinium ions, pyrrolidinium ions, ammonium ions, piperidinium ions, and phosphonium ions. Among these, at least one selected from the group consisting of ammonium ions and imidazolium ions is preferable. That is, the ionic liquid is preferably at least one ionic liquid selected from the group consisting of an ammonium-based ionic liquid and an imidazolium-based ionic liquid.

Ammonium ions generally have a higher resistance to reduction potential, that is, a wider potential window, than other cation frameworks. Therefore, in dielectrics for transducer applications that may be exposed to high electric fields in some cases, ionic liquids composed of ammonium ions, which are unlikely to undergo the electrolytic reaction, are suitably used.

In addition, the reason why imidazolium ions can be suitably used is as follows. As described above, the polyether structure derived from polyether polyurethane comprised in the domain of the polyurethane elastomer stabilizes cations, and thus excellent dielectric properties are exhibited. In this regard, since imidazolium ions have delocalized positive charges and are planar, they are easily stabilized according to the polyether structure, and the Coulomb interaction with anions is relatively weaker than that of other cation frameworks, and thus a high-level increase in dielectric constant can be expected. In addition, due to the charge delocalization, an ionic liquid composed of imidazolium ions generally has a lower viscosity than that of other cation frameworks, and is preferable in consideration of handling in the dielectric manufacturing step.

Ammonium ions may be, for example, at least one selected from the group consisting of quaternary ammonium salts such as N-trimethyl-N-propylammonium, N-trimethyl-N-butylammonium, bis(2-hydroxyethyl)-methyl-octylammonium, bis(2-hydroxyethyl)-methyl-decylammonium, N,N-diethyl-N-methyl-N-(2-methoxyethyl)ammonium, and N,N-(2-hydroxyethyl)-N-(9-octadecene)-N-methylammonium.

In addition, imidazolium ions may be, for example, at least one selected from the group consisting of 1-ethyl-2,3-dimethylimidazolium, 1-butyl-2,3-dimethylimidazolium, 1-hexyl-2,3-dimethylimidazolium, 1,3-bis(2-hydroxyethyl)imidazolium, 1-(2-hydroxyethyl)-3-methylimidazolium, 1-(3-hydroxypropyl)-3-methylimidazolium, 1-butyl-3-(2-hydroxyethyl)imidazolium, and 1-ethyl-3-(2-hydroxyethyl)imidazolium.

The anionic component is not particularly limited, and may be, for example, at least one selected from the group consisting of halogen ions, $BF_4^-$, $PF_6^-$, $CF_3SO_3^-$, $(CF_3SO_2)_2N^-$, and $(FSO_2)_2N^-$. In order to improve dielectric properties, it is preferable that the interaction between cations and anions not be strong. Therefore, at least one selected from the group consisting of $BF_4^-$, $PF_6^-$, $CF_3SO_3^-$, $(CF_3SO_2)_2N^-$, and $(FSO_2)_2N^-$, which are anions with large molecular volumes, is particularly preferable. The anion is more preferably at least one anion selected from the group consisting of $BF_4^-$, $PF_6^-$, $CF_3SO_3^-$ and $(CF_3SO_2)_2N^-$.

In addition, the ionic liquid preferably has a reactive functional group that reacts with an isocyanate group. Examples of reactive functional groups that react with an isocyanate group include a hydroxyl group. Since the ionic liquid has a reactive functional group that reacts with an isocyanate group, it reacts with a polyisocyanate used in a step of manufacturing the polyurethane elastomer to be described below, and is incorporated into the polymer network. This restricts the mobility of the ionic liquid when an electric field is applied, and can minimize a decrease in the resistance to dielectric breakdown due to space charge accumulation. In addition, incorporation of the ionic liquid into the polymer network is also useful in order to prevent the ionic liquid from bleeding out over time. For example, it is preferable that cations have a hydroxyl group.

Specific examples of ionic liquids that can be suitably used in the present disclosure include at least one selected from the group consisting of 1-ethyl-3-methylimidazolium bis(trifluoromethanesulfonyl)imide, 1-butyl-3-methylimidazolium bis(trifluoromethanesulfonyl)imide, 1-hexyl-3-methylimidazolium bis(trifluoromethanesulfonyl)imide, 1-ethyl-2,3-dimethylimidazolium bis(trifluoromethanesulfonyl)imide, 1-butyl-2,3-dimethylimidazolium bis(trifluoromethanesulfonyl)imide, 1-hexyl-2,3-dimethylimidazolium bis(trifluoromethanesulfonyl)imide, 1,3-bis(2-hydroxyethyl)imidazolium bis(trifluoromethanesulfonyl)imide, 1-(2-hydroxyethyl)-3-methylimidazolium bis(trifluoromethanesulfonyl)imide, 1-(3-hydroxypropyl)-3-methylimidazolium bis(trifluoromethanesulfonyl)imide, 1-ethyl-1-methylpyrrolidinium bis(trifluoromethanesulfonyl)imide, 1-methyl-1-propylpyrrolidinium bis(trifluoromethanesulfonyl)imide, 1-butyl-1-methylpyrrolidinium bis(trifluoromethanesulfonyl)imide, 1-ethylpyridinium bis(trifluoromethanesulfonyl)imide, 1-propylpyridinium bis(trifluoromethanesulfonyl)imide, 1-methyl-1-propylpiperidinium bis(trifluoromethanesulfonyl)imide, 1-butyl-1-methylpiperidinium bis(trifluoromethanesulfonyl)imide, N-trimethyl-N-propylammonium bis(trifluoromethanesulfonyl)imide, N-trimethyl-N-butylammonium bis(trifluoromethanesulfonyl)imide, bis(2-hydroxyethyl)-methyl-octylammonium bis(trifluoromethanesulfonyl)imide, bis(2-hydroxyethyl)-methyl-decylammonium bis(trifluoromethanesulfonyl)imide, N,N-diethyl-N-methyl-N-(2-methoxyethyl)ammonium bis(trifluoromethanesulfonyl)imide, and N,N-(2-hydroxyethyl)-N-(9-octadecene)-N-methylammonium bis(trifluoromethanesulfonyl)imide.

In addition, examples of commercially available ionic liquid products include "ELEXCEL AS-110," "ELEXCEL MP-442," "ELEXCEL IL-210," "ELEXCEL MP-471," "ELEXCEL MP-456," and "ELEXCEL AS-804" (commercially available from DKS Co., Ltd.), "HMI-FSI" (commercially available from Mitsubishi Materials Corporation), "CIL-312," "CIL-542" and "CIL-313" (commercially available from Japan Carlit Co., Ltd.), and IL-P series, IL-A series, IL-C series, IL-IM series, IL-AP series, and IL-OH series (commercially available from Koei Chemical Co., Ltd.), but the present invention is not particularly limited thereto.

The ionic liquid is preferably predominantly distributed in the matrix of the dielectric. Here, the term "predominantly distributed" means that the value ratio D/C of the concentration D to the concentration C defined as follows satisfies D/C>1.0. The concentration of the ionic liquid per 50 μm×50 μm observation region observed in a cross section in which the domain and the matrix of the dielectric are exposed is defined as the concentration C. In addition, the concentration of the ionic liquid comprised in the matrix in the 50 μm×50 μm observation region is defined as the concentration D.

D/C is preferably 1.0 to 3.0, more preferably 1.2 to 2.0, and still more preferably 1.3 to 1.7.

D/C can be increased by decreasing the area ratio of matrix/domain in the dielectric. In addition, D/C can be decreased by increasing the area ratio of matrix/domain in the dielectric.

When the ionic liquid is predominantly distributed in the matrix, favorable resistance to dielectric breakdown is easily obtained. To explain the reason for this, a case in which the ionic liquid is present in a large amount in domains formed of polyether urethane is considered. In this case, it is thought that, since a weak intermolecular force acts between polyether chains, an environment in which ions can easily move is created, and the ions are concentrated at the domain-matrix interface when the electric field is applied.

Generally, the concentration of ions at the interface is alleviated when the electric field is released, but when the dielectric is used for a transducer application, the above phenomenon occurs repeatedly when the electric field is repeatedly applied, and thus bias of ionic charges is fixed. In this case, it is thought the electric field is locally concentrated in places inside the dielectric, which creates an environment in which dielectric breakdown is likely to occur. For the above reason, it is preferable that the ionic liquid be predominantly distributed in the matrix of the dielectric. In order for the ionic liquid to be distributed predominantly in the matrix, it is effective to clarify the phase separation between the matrix and the domain, and it is preferable that the matrix comprise a second structure comprising a polycarbonate structure represented by Formula (2).

More preferably, the ionic liquid is preferably predominantly distributed in the matrix in the vicinity of the interface between the matrix and the domain. Here, the term "predominantly distributed in the vicinity of the interface" means that the concentration D and the following concentration D3 satisfy D3/D>1.0. The concentration D3 is a concentration of the ionic liquid comprised in the vicinity of the interface with the domain in the matrix in a 50 μm×50 μm observation region observed in a cross section in which the domain and the matrix of the dielectric are exposed.

The definition of the vicinity of the interface will be described below. When the ionic liquid is arranged in this manner, cations are effectively stabilized according to the ether structure of the polyether polyurethane, and thus a higher-level increase in dielectric constant can be expected.

A method for calculating the concentrations C and D of the ionic liquid will be described. First, a dielectric is sliced into thin sections. As a thin sectioning device, a microtome may be exemplified.

In the cross section of the obtained sections, arbitrary observation regions of 50 μm squares are set, and mass spectra fragment ions detected in the observation regions are obtained using a time-of-flight secondary ion mass spectrometer (TOF-SIMS). Examples of time-of-flight secondary ion mass spectrometers (TOF-SIMS) include nanoTOF II (commercially available from ULVAC-PHI, Inc.).

Among the mass spectra of fragment ions obtained in the observation regions, the intensity of cations or anions of the ionic liquid, or fragment ions corresponding to their decomposition products is expressed as the brightness of the observation region and a brightness profile of the observation region is created. Next, the average brightness in the entire observation region is defined as the concentration C of the ionic liquid in the observation region. In addition, the average brightness of the region within the observation region corresponding to the matrix is defined as the concentration D of the ionic liquid comprised in the matrix.

Here, the definition of the vicinity of the interface and a method for calculating the concentration D3 of the ionic liquid in the vicinity of the interface will be further described. A region of an arbitrary domain is set as a1, and its geometric center is set as c1. In addition, a region a2 that has the same geometric center c1 and has a shape similar to a1, with a similarity of 1.2 is considered.

In this case, the region a3 obtained by removing a1 from a2 is defined as the vicinity of the interface of the domain in the matrix. In this manner, the union of the vicinity regions a3 defined for each domain is defined as A3, and the region A3 is defined as the vicinity of the interface. For the brightness profile in the above observation region, the concentration D3 of the ionic liquid in the vicinity of the interface can be obtained by calculating the average brightness in the region A3.

Here, when a3 includes other domains, such as when the distance between the domains is short, the domain part

is excluded from a3.

The content of the ionic liquid in the dielectric based on the mass of the dielectric is preferably 0.5 to 8.0 mass%, more preferably 2.0 to 8.0 mass%, and still more preferably 2.0 to 3.0 mass%. When the content of the ionic liquid is 0.5 mass% or more, a higher-level increase in dielectric constant can be expected compared to when the content is less than that value. In addition, when the content of the ionic liquid is 2.0 mass% or more, predominant distribution of the ionic liquid at the matrix-domain interface occurs effectively, and an even higher-level increase in dielectric constant can be expected. In addition, when the content of the ionic liquid is 8.0 mass% or less, it becomes easier to achieve both a high dielectric constant and resistance to dielectric breakdown.

Confirmation of the presence of the ionic liquid in the dielectric and calculation of the content of the ionic liquid can be performed by the following method. The ionic liquid can exist in two forms according to the presence of the reactive functional group that reacts with an isocyanate group and the reactivity of the reactive group. That is, there are two forms: a form in which the ionic liquid is incorporated into the polymer network via an isocyanate group and a form in which the ionic liquid is not incorporated into the polymer network but remains free.

The content of the ionic liquid in the former form can be identified by structural analysis using, for example, NMR, GC-MS, or LC-MS. The content of the ionic liquid in the latter form can be determined by extracting the ionic liquid from the surface layer and performing quantifying. As the solvent used for extraction, a solvent that can dissolve the ionic liquid is selected. Specific examples thereof include methyl ethyl ketone (MEK). Here, the solvent in the extraction liquid after extraction is removed using a rotary evaporator or the like, the ionic liquid is isolated by various types of chromatography, and thus the content proportion of the ionic liquid in the dielectric can be quantified.

<Dielectric>

The relative dielectric constant of the dielectric is preferably 10.0 or more. More preferably, it should be 15.0 or more. Here, the relative dielectric constant in the present disclosure is a relative dielectric constant observed when an AC voltage of 100 Hz is applied at room temperature. The upper limit of the relative dielectric constant is not particularly limited. The relative dielectric constant is preferably 10.0 to 200.0, and more preferably 15.0 to 100.0.

When the relative dielectric constant is within the above range, the dielectric can be more suitably used as a transducer dielectric having excellent conversion efficiency between electrical energy and mechanical energy. The relative dielectric constant can be obtained using an impedance analyzer (1260A, commercially available from Solartron) and a dielectric interface (1296A, commercially available from Solartron), inserting a dielectric into a four-terminal sample holder (SH2-Z type, commercially available from Toyo Corporation), performing sweeping at room temperature with an AC voltage of 0.1 Vpp and a frequency of 0.01 Hz to 1 MHz, and measuring the relative dielectric constant at 100 Hz.

The relative dielectric constant of the dielectric can be controlled by the amount of the domain material and matrix material used (area ratio of matrix/domain), the chemical structure, and the content of the ionic liquid.

In addition, the Young's modulus of the dielectric is preferably 2.5 MPa or less. More preferably. it should be 0.1 to 2.5 MPa, and still more preferably 1.0 to 2.2 MPa. Here, in the present disclosure, the Young's modulus is the real part of the complex elastic modulus obtained when a sinusoidal strain of 1 Hz is applied at room temperature. When the Young's modulus is within the above range, the dielectric can be deformed flexibly against an external force such as compression and tension. The Young's modulus can be obtained by measuring the dependence of the complex elastic modulus on frequency using a viscoelasticity measurement device (product name: Rheogel-E4000, commercially available from UBM).

The Young's modulus can be controlled by the amount of the domain material and matrix material used (area ratio of matrix/domain), the chemical structure, and the crosslink density.

In addition, the hysteresis loss of the dielectric is preferably 10% or less, and more preferably 6% or less. Here, the hysteresis loss in the present disclosure is a value calculated from the following formula when a stress-strain curve is obtained for the dielectric under conditions of a displacement of 33%, a displacement speed of 0.275 mm/sec, and a number of reciprocating displacements of 5 at room temperature.

$$\text{Hysteresis loss [\%]}=(1-(\text{elasticity deformation workload/total deformation workload}))\times 100$$

The hysteresis loss can be controlled by the amount of the domain material and matrix material used (area ratio of matrix/domain), the chemical structure, and the crosslink density.

When the hysteresis loss is within the above range, the dielectric can be more suitably used as a transducer dielectric with excellent recovery and low energy loss associated with displacement. The hysteresis loss can be calculated by measuring a stress-strain curve according to the above protocol using a viscoelasticity measurement device (product name: Rheogel-E4000, commercially available from UBM) in a tension mode.

A lower hysteresis loss is preferable, and the lower limit is not particularly limited. The hysteresis loss may be, for

example, 0 to 10%, or 1 to 6%.

In addition, the dielectric breakdown strength of the dielectric is preferably 15 kV/mm or more and more preferably 20 kV/mm or more. Here, the dielectric breakdown strength in the present disclosure is defined as an electric field intensity at which a leak current of more than 5 mA is detected in a dielectric with no strain applied at room temperature. When the dielectric breakdown strength is within the above range, the dielectric can be suitably used as a transducer dielectric that can withstand usage under a higher voltage condition. The dielectric breakdown strength can be obtained by detecting a leak current while changing the electric field intensity applied to the dielectric using a withstand voltage tester (GPT-9903A, commercially available from Texio Technology Corporation).

The upper limit of the dielectric breakdown strength is not particularly limited. The dielectric breakdown strength is, for example, 15 to 100 kV/mm, 20 to 50 kV/mm.

The dielectric breakdown strength can be controlled by the amount of the domain material and matrix material used (area ratio of matrix/domain), the chemical structure, and the content of the ionic liquid.

<Method for Manufacturing Dielectric>

A dielectric can be synthesized by, for example, a method including the following steps (i) to (iv). The dielectric is preferably a dielectric manufactured by the method including the following steps (i) to (iv).

Step (i): a step of obtaining a second urethane prepolymer having at least two hydroxyl groups by reacting a first urethane prepolymer having at least one isocyanate group (preferably at least two isocyanate groups) with a first polycarbonate polyol having at least two hydroxyl groups

Step (ii): a step of obtaining a first dispersion by dispersing droplets comprising at least a part of the second urethane prepolymer in a second polycarbonate polyol (which may be an excess unreacted component of the first polycarbonate polyol)

Step (iii): a step of obtaining a second dispersion by dispersing an ionic liquid in the first dispersion

Step (iv): a step of preparing a dielectric forming mixture comprising the second dispersion and a polyisocyanate having at least two isocyanate groups, and then reacting the second urethane prepolymer, the second polycarbonate polyol, (the ionic liquid when the ionic liquid comprises a hydroxyl group), and the polyisocyanate having at least two isocyanate groups in the dielectric forming mixture to form a dielectric.

One aspect of the above method for manufacturing a dielectric will be described with reference to Fig. 1. Here, the method for manufacturing a dielectric is not limited to this aspect.

In the step (i), a first urethane prepolymer 51 having at least one isocyanate group, preferably at least two isocyanate groups, and a first polycarbonate polyol 52 having at least two hydroxyl groups are mixed. Next, the isocyanate groups and the hydroxyl groups in the mixture obtained in the presence of a curing catalyst are reacted with each other to link them via urethane bonds, and thus a second urethane prepolymer 53 having at least two hydroxyl groups is obtained.

Here, in Fig. 1, a polyether having two isocyanate groups is shown as an example of the first urethane prepolymer 51. The first urethane prepolymer 51 may be, for example, one comprising a second structure, and is preferably a reaction product of a polyol such as polyether diol and a polyisocyanate.

In the step (ii), a dispersion in which droplets comprising at least a part of the second urethane prepolymer are dispersed in a second polycarbonate polyol is obtained. Here, the second urethane prepolymer can be mixed with a second polycarbonate polyol that is newly added in this step. In addition, an excess unreacted component of the first polycarbonate polyol in the step (i) can also be used as the second polycarbonate polyol.

The first urethane prepolymer 51 comprised in the second urethane prepolymer 53 is incompatible with a second polycarbonate polyol 55 and forms droplets 54.

On the other hand, the first polycarbonate polyol 52 comprised in the second urethane prepolymer 53 is compatible with the second polycarbonate polyol 55. Therefore, the droplets 54 comprising the first urethane prepolymer 51 constituting a part of the second urethane prepolymer 53 are uniformly and stably dispersed in the second polycarbonate polyol 55 via the first polycarbonate polyol 52. As a result, a first dispersion in which the droplets 54 comprising the first urethane prepolymer 51 (second structure) are dispersed in the second polycarbonate polyol 55 is obtained.

In the step (ii), the second polycarbonate polyol 55 in which the droplets 54 are dispersed may be the unreacted component of the first polycarbonate polyol used in the step (i) with the first urethane prepolymer. That is, in the step (i), when an excess amount of the first polycarbonate polyol relative to the first urethane prepolymer is used, it is possible to obtain a dispersion in which the second urethane prepolymer 53 described in the step (ii) is dispersed in an excess amount of the first polycarbonate polyol (that is, the second polycarbonate polyol 55).

Here, even when an excess amount of the first polycarbonate polyol is used, it is possible to add a polycarbonate polyol (second polycarbonate polyol) as a dispersion medium for the second urethane prepolymer. In this case, the

polycarbonate polyol to be added may have the same chemical composition as the first polycarbonate polyol used in the step (i) or may have a different chemical composition.

On the other hand, in the step (i), when the first polycarbonate polyol and the first urethane prepolymer are reacted in equivalent amounts, and the first polycarbonate polyol is completely consumed, in the step (ii), a new polycarbonate polyol is used as the second polycarbonate polyol to prepare a dispersion. In this case, the polycarbonate polyol used as the second polycarbonate polyol may have the same chemical composition as the first polycarbonate polyol or may have a different chemical composition.

Here, when an excess unreacted component of the first polycarbonate polyol is used as the second polycarbonate polyol, the step (i) and the step (ii) can be performed simultaneously.

In the step (iii), a second dispersion in which an ionic liquid is dispersed in the first dispersion obtained in the step (ii) is obtained. As a dispersion method, any known method such as mechanical stirring can be used.

Finally, in the step (iv), a dielectric forming mixture comprising the second dispersion prepared in the step (iii) and a polyisocyanate 56 having at least two isocyanate groups is prepared. Next, the terminal hydroxyl groups of the second urethane prepolymer 53, the hydroxyl groups of the second polycarbonate polyol 55, and the isocyanate groups of the polyisocyanate 56 in the dielectric forming mixture are reacted with each other.

It is preferable that the ionic liquid comprise a hydroxyl group. In the step (iv), it is preferable that the second urethane prepolymer, the second polycarbonate polyol, the ionic liquid, and the polyisocyanate having at least two isocyanate groups in the dielectric forming mixture be reacted with each other to form a dielectric.

In this manner, a network structure is formed via a urethane bond, and the dielectric forming mixture is cured to obtain the dielectric according to the present disclosure. A dielectric 33 obtained in this manner has a matrix-domain structure in which a domain 32 comprising a polyether structure derived from the first urethane prepolymer 51, that is, a first structure, is dispersed in a matrix 31 comprising a urethane elastomer having a polycarbonate structure derived from the first polycarbonate polyol 52 and the second polycarbonate polyol 55, that is, a second structure.

In addition, the domain 32 can be mainly composed of a polyether structure (first structure), and the inside of the domain can be substantially free of a cross-linked structure. In other words, the domain 32 can be present in a substantially liquid state in the matrix. Therefore, in the dielectric 33 according to the present disclosure, the domain can have a low elastic modulus.

In addition, in the domain, the liquid part is not simply trapped in the matrix, and the domain and the matrix are chemically bonded via a urethane bond at the boundary part the domain and the matrix. Therefore, when the load applied to the dielectric 33 is removed, the recovery of the domain from deformation can be linked to the recovery of the matrix from deformation.

That is, the inside of the substantially liquid domain is substantially free of, for example, a cross-linked structure. Therefore, it is difficult for the domain deformed by a load applied to the dielectric 33 to recover from deformation autonomously. However, in the dielectric according to the present disclosure, the domain is chemically bonded (via a urethane bond) to the matrix at the boundary part between the domain and the matrix, and thus the matrix can be recovered from deformation and the domain can also be recovered from deformation. Therefore, even when the dielectric 33 is repeatedly subjected to loading and unloading, stable deformation (amount of deformation), and stable recovery from the deformation are achieved, and it is easier to achieve a low hysteresis loss.

In order to distribute the ionic liquid predominantly in the matrix, it is preferable to disperse the ionic liquid after the step (ii) as described above. In the step (ii), since the interface between the matrix and the domain is firmly formed via a chemical bond (urethane bond), the ionic liquid is prevented from entering the domain, and a state in which the ionic liquid is predominantly distributed in the matrix can be achieved. Alternatively, in the step (ii), the ionic liquid can be dispersed well in the matrix by using a second polycarbonate polyol in which the ionic liquid has been dispersed in advance and omitting the step (iii).

Here, the steps (i) to (iv) are steps of stably and uniformly dispersing the polyether polyol in the polycarbonate polyol when the compatibility between the polycarbonate polyol used as the matrix and the polyether polyol used as the domain is low. That is, the first urethane prepolymer 51 is reacted with the first polycarbonate polyol 52 to form the second urethane prepolymer 53.

Therefore, it is possible to obtain a dispersion in which polyether polyol segments derived from the first urethane prepolymer 51 are stably and uniformly dispersed in the second polycarbonate polyol. Therefore, it is easy to prepare the dielectric 33 in which the domains 32 having a high circularity, small sizes on the micrometer order, and a relatively uniform size distribution are dispersed in the matrix 31.

Here, another method for mixing materials with low compatibility is, for example, a mixing and dispersing method using a high shear force. However, in this method, a high shear force is applied to the polyol comprising the first structure, and as a result, the shapes of the domains are distorted, the circularity decreases, and the sizes of the domains also become non-uniform. In addition, the dispersion state is also unstable, and the domains aggregate in a relatively short time.

In addition, the incompatibility between polyether polyol and polycarbonate polyol is not secured, and the phase

separation between the matrix and the domain of the obtained urethane elastomer becomes unclear. Therefore, predominant distribution of the ionic liquid in the matrix is not secured, which leads to a decrease in resistance to dielectric breakdown. In addition, unclear phase separation also influences mechanical properties, and it is difficult to obtain a dielectric having excellent flexibility and low hysteresis loss properties according to the present disclosure.

The amounts of the polyol comprising a first structure and the polyol comprising a second structure used are not particularly limited, and may be any amount at which droplets 54 can be dispersed in the second polycarbonate polyol 55 to form clear domains. For example, the ratio of the polyol comprising a first structure to the polyol comprising a second structure based on the mass is preferably 15:85 to 50:50, and more preferably 20:80 to 50:50.

The first urethane prepolymer is a polyether having at least one isocyanate group and a structure represented by Formula (1). The first urethane prepolymer can be obtained by, for example, the following step.

A polyether polyol having at least two hydroxyl groups and a structure represented by Formula (1) is reacted with a polyisocyanate having at least two isocyanate groups.

Examples of polyether polyols include alkylene structure-containing polyether-based polyols such as polypropylene glycol, polytetramethylene glycol, copolymers of tetrahydrofuran and neopentyl glycol, copolymers of tetrahydrofuran and 3-methyltetrahydrofuran, and random or block copolymers of these polyalkylene glycols. These may be used alone or two or more thereof may be used in combination.

Among these polyether polyols, an amorphous polyether polyol is preferable because the mobility of ether groups is high, the effect of stabilizing cations is strong, and low hardness can be achieved. Among polyether polyols, it is more preferable to comprise at least one selected from among polypropylene glycol, copolymers of tetrahydrofuran and neopentyl glycol, copolymers of tetrahydrofuran and 3-methyltetrahydrofuran. It is still more preferable to comprise at least polypropylene glycol.

The number average molecular weight of the polyether polyol is preferably from 1,000 to 50,000, and more preferably from 1,200 to 30,000. When the number average molecular weight is 1,000 or more, the segments including a polyether structure easily form a domain. In addition, when the number average molecular weight is 50,000 or less, this is preferable because the phase separation structure is better stabilized.

Examples of polyisocyanates to be reacted with the polyether polyol include pentamethylene diisocyanate, hexamethylene diisocyanate, isophorone diisocyanate, 2,4-tolylene diisocyanate, 2,6-tolylene diisocyanate, xylylene diisocyanate, diphenylmethane diisocyanate, or trimeric compounds (isocyanurate) or polymeric compounds of these polyisocyanates, allophanate type polyisocyanates, buret type polyisocyanates, and water-dispersing type polyisocyanates. These polyisocyanates may be used alone or two or more thereof may be used in combination.

Among the polyisocyanates exemplified above, a bifunctional isocyanate having two isocyanate groups (diisocyanate) is preferable because it has high compatibility with polyether polyols, and physical properties such viscosity are easily adjusted. Among the above polyisocyanates, it is more preferable to comprise at least one selected from among hexamethylene diisocyanate, isophorone diisocyanate, 2,4-tolylene diisocyanate, 2,6-tolylene diisocyanate, xylylene diisocyanate, and diphenylmethane diisocyanate. Xylylene diisocyanate is still more preferable.

In the step of obtaining the first urethane prepolymer by reacting the polyether polyol comprising a structure represented by Formula (1) with the polyisocyanate, the isocyanate index is preferably 0.05 to 8.0, and more preferably 0.1 to 5.0. When the isocyanate index is within the above range, the amount of components derived from the first urethane prepolymer that remains without being formed into a network structure can be reduced, and exudation of liquid substances from the polyurethane elastomer can be curbed.

Here, the isocyanate index indicates the ratio ([NCO]/[OH]) of the number of moles of isocyanate groups in an isocyanate compound to the number of moles of hydroxyl groups in a polyol compound.

The first urethane prepolymer obtained by reacting a polyether polyol comprising a structure represented by Formula (1) with a polyisocyanate has a structure in which hydroxyl groups and isocyanate groups are reacted with each other to link them via urethane bonds. The number average molecular weight is preferably from 1,000 to 100,000, and more preferably from 1,200 to 50,000.

The first polycarbonate polyol is not particularly limited as long as it is phase-separated from the first urethane prepolymer, and is preferably a polycarbonate polyol having at least two hydroxyl groups and a structure represented by Formula (2). Examples of first polycarbonate polyols include reaction products of polyhydric alcohols and phosgene, and ring-opening polymers of cyclic carbonates (alkylene carbonates, etc.).

Examples of polyhydric alcohols include propylene glycol, dipropylene glycol, trimethylene glycol, 1,4-tetramethylenediol, 1,3-tetramethylenediol, 2-methyl-1,3-trimethylenediol, 1,5-pentamethylenediol, neopentyl glycol, 1,6-hexamethylenediol, 3-methyl-1,5-pentamethylenediol, 2,4-diethyl-1,5-pentamethylenediol, glycerin, trimethylolpropane, trimethylolethane, cyclohexanediols (1,4-cyclohexanediol, etc.), and sugar alcohols (xylitol, sorbitol, etc.).

Examples of alkylene carbonates include trimethylene carbonate, tetramethylene carbonate, and hexamethylene carbonate.

The number average molecular weight of the first polycarbonate polyol (Mn) is preferably from 500 to 10,000 and more preferably from 700 to 8,000. When the number average molecular weight is 500 or more, low compatibility with the

polyurethane segments comprising a polyether structure represented by Formula (1) is secured, and the phase separation between the matrix and the domain can be clearer. In addition, when the number average molecular weight is 10,000 or less, this is preferable because difficulty in handling caused by an increase in viscosity of the polycarbonate polyol as a raw material is prevented.

The number average molecular weight of the first polycarbonate polyol can be calculated using the hydroxyl value (mg KOH/g) and the valence, similarly to the number average molecular weight of the polyether polyol.

As the polyisocyanate 56 having at least two isocyanate groups used in the step (iv), the same polyisocyanate as those exemplified as the raw material for the first urethane prepolymer can be used. These polyisocyanates may be used alone or two or more thereof may be used in combination.

As the polyisocyanate used in the step (iv), among the polyisocyanates exemplified above, in order to increase the elastic modulus of the matrix, it is preferable to include a polyisocyanate having at least three isocyanate groups such as a trimeric compound (isocyanurate) or polymeric compound of a polyisocyanate, an allophanate type polyisocyanate, and a buret type polyisocyanate.

More preferably, at least one selected from the group consisting of a trimeric compound (isocyanurate) of pentamethylene diisocyanate, a trimeric compound (isocyanurate) of hexamethylene diisocyanate, a polymeric compound of diphenylmethane diisocyanate, and polymeric MDI can be used. Curing catalysts for urethane elastomers are roughly classified into urethanization catalysts (reaction accelerating catalysts) for accelerating rubberization (resinization) and foaming and isocyanuration catalysts (isocyanate trimerization catalysts). In the present disclosure, these may be used alone or in combination.

Among the above examples, polymeric MDI is preferable. Here, polymeric MDI is a mixture of monomeric MDI and a high-molecular-weight polyisocyanate, and is represented by the following Formula (A). In Formula (A), n is preferably from 0 to 4.

As the polymeric MDI, commercially available products may be used, and examples thereof include Millionate MR series (commercially available from Tosoh Corporation) such as Millionate MR200 (product name).

[C4]

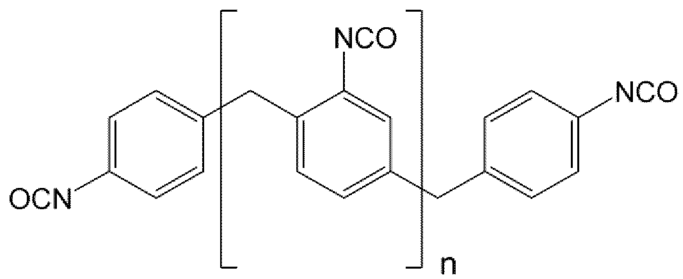

(A)

As the polyisocyanate 56 having at least two isocyanate groups, it is preferable to use a polyisocyanate having at least three isocyanate groups such as polymeric MDI in combination with a bifunctional isocyanate having two isocyanate groups. According to the above combination, the crosslink density can be controlled, and thus the combination is preferable because both low hardness and low compression permanent strain are achieved.

The amounts of the polyisocyanate having at least three isocyanate groups and the bifunctional isocyanate having two isocyanate groups are not particularly limited. The ratio of the amounts of the bifunctional isocyanate:polyisocyanate having at least three isocyanate groups when mixed into the dispersion in the step (iv) is preferably 3:1 to 1:10, and more preferably 1: 1 to 1:6. The amount of polyisocyanate per 100 parts by mass of the dispersion in the step (iv) is not particularly limited, and may be, for example, 1 to 10 parts by mass, or 3 to 8 parts by mass.

Examples of urethanization catalysts include tin-based urethanization catalysts such as dibutyltin dilaurate and stannous octoate, and amine-based urethanization catalysts such as triethylenediamine, tetramethylguanidine, pentamethyldiethylenetriamine, diethyl imidazole, tetramethylpropanediamine, N,N,N'-trimethylaminoethylethanolamine, and 1,4-diazabicyclo[2.2.2]octane-2-methanol. These may be used alone or in combination. Among these urethanization catalysts, triethylenediamine, and 1,4-diazabicyclo[2.2.2]octane-2-methanol are preferable because they particularly accelerate the urethane reaction.

Examples of isocyanuration catalysts include metal oxides such as $Li_2O$ and $(Bu_3Sn)_2O$, hydride compounds such as $NaBH_4$, alkoxide compounds such as $NaOCH_3$, KO-(t-Bu), and borate, amine compounds such as $N(C_2H_5)_3$, $N(CH_3)_2CH_2C_2H_5$, and 1,4-ethylenepiperazine (DABCO), alkaline carboxylate compounds such as HCOONa, $Na_2CO_3$, PhCOONa/DMF, $CH_3COOK$, $(CH_3COO)_2Ca$, alkaline soap, and naphthenate, alkaline formate compounds, and quaternary ammonium salt compounds such as $((R)_3\text{-NR'OH})\text{-OCOR''}$.

In addition, examples of combined catalysts (cocatalysts) used as isocyanuration catalysts include amine/epoxide, amine/carboxylic acid, and amine/alkyleneimide. These isocyanuration catalysts and combined catalysts may be used alone or in combination.

As a catalyst for urethane synthesis, N,N,N'-trimethylaminoethylethanolamine (hereinafter referred to as ETA), which acts alone as a urethanization catalyst and also acts as an isocyanuration catalyst may be used.

In the method for manufacturing a dielectric, as necessary, a chain extension agent (multifunctional low-molecular-weight polyol) may be used. The chain extension agent may be, for example, a glycol having a number average molecular weight of 1,000 or less.

Examples of glycols include ethylene glycol (EG), diethylene glycol (DEG), propylene glycol (PG), dipropylene glycol (DPG), 1,4-butanediol (1,4-BD), 1,6-hexanediol (1,6-HD), 1,4-cyclohexanediol, 1,4-cyclohexane dimethanol, xylylene glycol (terephthalyl alcohol), and triethylene glycol.

In addition, examples of chain extension agents other than glycols include trihydric or higher polyhydric alcohols. Examples of trihydric or higher polyhydric alcohols include trimethylolpropane, glycerin, pentaerythritol, and sorbitol. These may be used alone or in combination.

In addition, as necessary, additives such as a conducting agent, a pigment, a plasticizer, a water-proofing agent, an antioxidant, a UV absorbing agent, and a light stabilizer may be used in combination.

<Transducer>

Another aspect of the present disclosure provides a transducer comprising the dielectric. The transducer comprises at least two electrodes and the dielectric inserted between the electrodes. Wirings for conducting electricity to a power supply or a control element may be connected to the electrodes. In addition, the dielectric and the electrodes may be alternately laminated to form a laminated structure.

Fig. 4 shows an example of a transducer according to the present disclosure. A transducer 6 comprises a dielectric 61 according to the present disclosure and a pair of electrodes 62 with the dielectric 61 therebetween. The application of the transducer is not particularly limited, and the transducer can be used, for example, as an actuator, a sensor, or a power generating element.

When the transducer is used as an actuator, a driving force can be induced in the dielectric 61 by applying a potential difference between the pair of electrodes 62 using an electric circuit device 7. When the transducer is used as a sensor, the amount of deformation can be obtained by measuring the change in capacitance due to expansion of the transducer 6 using the electric circuit device 7. When the transducer is used as a power generating element, the electrical energy according to deformation of the transducer by, for example, a known method described in Sustainability 2021, 13(17), 9881, can be obtained.

The thickness of the dielectric 61 may be appropriately determined depending on the application of the transducer 6, and when the transducer is used as an actuator, a thinner dielectric layer is preferable in order for miniaturization, low-voltage driving, and increasing the amount of displacement. In consideration of resistance to dielectric breakdown, the thickness of the dielectric layer is preferably from 1 $\mu$m to 1,000 $\mu$m.

The material of the electrode 62 may be a general conductive material, and examples thereof include conductive carbon powders such as carbon black, carbon nanotubes, graphite, and graphene, metal powders such as silver, gold, copper, nickel, rhodium, palladium, chromium, titanium, platinum, iron, and alloys thereof, metal colloids such as colloidal silver, charge transfer complexes such as tetrathiafulvalene/tetracyanoquinodimethane, and conductive polymers such as polypyrrole and polythiophene. A member having elasticity that allows it to conform to expansion of the dielectric used is preferable.

Examples of such electrode members include composite materials formed of the above conductive material and a binder. Examples thereof include a composite material in which a conductive material filler is dispersed in an acrylic-based, silicon-based, urethane-based, or styrene-based elastomer material, silicone grease or the like, and a poly(3,4-ethylenedioxythiophene)/poly(4-styrenesulfonic acid)(PEDOT/PSS) aqueous dispersion comprising an appropriate amount of an organic solvent, a resin, a crosslinking agent or the like.

A method for manufacturing a transducer according to the present disclosure is not particularly limited, and examples thereof include a method for spraying an electrode material onto a dielectric according to the present disclosure, a method for bonding an electrode material and a dielectric, a method for impregnating or dispersive-incorporating a dielectric into an electrode material, and a method for applying or printing an electrode material onto a dielectric.

When the dielectric of the present disclosure having excellent dielectric properties and having low hysteresis loss and flexibility in combination is used as a dielectric of the transducer, it is possible to realize an actuator that is excellent in terms of an increased amount of deformation, an increased output, high efficiency, drive stabilization, low-voltage driving and the like. In addition, in sensor applications, it is possible to provide a sensor that is excellent in terms of high efficiency, a high capacity, miniaturization, and recovery from deformation. Similarly, when the transducer is used as a power generating element, it is possible to provide an element that is excellent in terms of high efficiency, a high output, miniaturization, an increased power generation amount and the like.

In addition, as described above, when the dielectric according to the present disclosure comprises a matrix comprising a polycarbonate structure represented by Formula (2), it has resistance to dielectric breakdown, wear resistance, and low friction properties in addition to the above properties. Therefore, when the transducer is used, it is possible to minimize dielectric breakdown due to application of a high electric field, reduce energy loss due to friction with surrounding members, and also minimize performance degradation due to wear.

[Examples]

The following describes Examples for the present disclosure, but the present disclosure is not limited to these embodiments.

<Materials used>

Materials used in Examples and Comparative Examples are listed below.

[Polyol]

·A-1: polyether diol (polypropylene glycol) [product name: PREMINOL S4013F, the number of carbon atoms for $R^1$=3 (branched), Mn=12,000, hydroxyl value: 9.4 mg KOH/g, commercially available from AGC]
·A-2: polyether diol (polypropylene glycol) [product name: Uniol D-2000, the number of carbon atoms for $R^1$=3 (branched), Mn=2,000, hydroxyl value: 55.0 mg KOH/g, commercially available from NOF Corporation]
·A-3: polyether diol (polytetramethylene glycol) [product name: PTMG4000, the number of carbon atoms for $R^1$=4 (linear), Mn=4,000, hydroxyl value: 29.1 mg KOH/g, commercially available from Mitsubishi Chemical Corporation]
·A-4: polycarbonate diol [product name: Kuraray Polyol C-2090, commercially available from Kuraray Co., Ltd., the number of carbon atoms for $R^2$=6 (linear)+6 (branched), Mn=2,000, commercially available from Kuraray Co., Ltd.]
·A-5: polycarbonate diol [product name: Duranol T6002, the number of carbon atoms for $R^2$=6 (linear), Mn=1,900, hydroxyl value: 57.6 mg KOH/g, commercially available from Asahi Kasei Chemicals Corporation]

Regarding the number of carbons of a polycarbonate diol, for example, the description of 6 (linear)+6 (branched) indicates that $R^2$ includes a linear structure having 6 carbon atoms and a branched structure having 6 carbon atoms.

[Polyisocyanate]

·B-1: xylylene diisocyanate [commercially available from Tokyo Chemical Industry Co., Ltd.]
·B-2: polymeric MDI [product name: Millionate MR-200, commercially available from Tosoh Corporation]

[Curing Catalyst]

·C-1: 1,4-diazabicyclo[2.2.2]octane-2-methanol (product name; RZETA) [commercially available from Tosoh Corporation]
·C-2: dibutyltin dilaurate [commercially available from Tokyo Chemical Industry Co., Ltd.]

[Ionic Liquid]

·E-1: 1,3-bis(2-hydroxyethyl)imidazolium bis(trifluoromethanesulfonyl)imide (synthesized by the method disclosed in Japanese Patent Application Publication No. 2021-113853)
·E-2: N,N-(2-hydroxyethyl)-N-(9-octadecene)-N-methylammonium bis(trifluoromethanesulfonyl)imide
·E-3: 1-ethyl-3-methylimidazoliumbis(trifluoromethanesulfonyl)imide (product name: EMITFSI, commercially available from Sigma-Aldrich)
·E-4: 1-(hydroxypropyl)pyridinium bis(trifluoromethanesulfonyl)imide

<Evaluation>

Hereinafter, evaluation methods in Examples and Comparative Examples are as follows.

[Evaluation 1: Confirmation and Analysis of Matrix and Domain]

A cryo-microtome system (product name: EM FC6, commercially available from Leica Microsystems) and an ultramicrotome (product name: EM UC6, commercially available from Leica Microsystems) were used to prepare ultrathin sections (500 μm×500 μm×5μm) from dielectrics. The sections were prepared in a total of three locations: the center of the dielectric and two locations sufficiently distant from the center.

Mapping measurement was performed on the prepared sections using an infrared microscope and imaging system (product name: Spectrum 400 (analysis device) and Spotlight400 (scanning device), commercially available from PerkinElmer) to create mapping images. For the measurement, mapping measurement was performed using an ATR imaging accessory under conditions: pixel size: 1.56 μm, resolution: 16 $cm^{-1}$, field of view: 300 μm×300 μm, and scanning speed: 1.0 cm/s. The mapping image is an image of the magnitude of the integrated value of the infrared absorption spectrum for each pixel.

The presence of the matrix mapped as a continuous phase and the domain mapped as a discontinuous phase was confirmed from the obtained mapping image. In addition, it was confirmed that the matrix included a second structure (for example, a structure corresponding to a polycarbonate diol) from the infrared absorption spectrum of the matrix of the mapping image. In addition, it was confirmed that the domain included a first structure (for example, a structure corresponding to a polypropylene glycol) from the infrared absorption spectrum of the domain of the mapping image. That is, it was confirmed that the matrix included a carbonate structure represented by Formula (2), and the domain included an ether structure represented by Formula (1).

[Evaluation 2: Evaluation of Parameter Indicating Viscoelasticity Term]

Ultrathin sections were prepared in the same manner as in Evaluation 1.

A total of three sections were prepared, arbitrary observation regions of 50 μm squares were selected, and viscoelastic images were observed in a total of three observation regions. Viscoelastic images were measured in a total of three observation regions using a scanning probe microscope (product name: S-Image, commercially available from SII NanoTechnology Inc.).

The measurement mode for the viscoelastic image was VE-DFM. In addition, as the cantilever, "SI-DF3" (product name, commercially available from Hitachi High-Tech Science Corporation, spring constant=1.9 N/m) was used. In addition, the scanning frequency was 0.5 Hz.

From the obtained viscoelastic image, in each observation region, the parameters indicating the viscoelasticity term were calculated for 10 points each for the matrix and the domain, and the parameter A (mV) indicating the viscoelasticity term of the domain and the parameter B (mV) indicating the viscoelasticity term of the matrix were calculated from their arithmetic average values.

Here, it was confirmed from the viscoelastic image taken by SPM that the domain was exposed and the matrix was exposed in the cross section.

[Evaluations 3 and 4: Evaluation of Concentrations D/C and D3/D of Ionic Liquid]

Ultrathin sections were prepared in the same manner as in Evaluation 1.

Arbitrary observation regions of 50 μm squares were selected from the cross section of the section, and the distribution of the ionic liquid was evaluated using a time-of-flight secondary ion mass spectrometer (TOF-SIMS). Used devices, measurement conditions and analysis methods are shown below.

·Measurement device: nanoTOF II (product name, commercially available from ULVAC-PHI, Inc.)
·Primary ion species: $Bi^{3++}$
·Accelerating voltage: 30 kV
·Primary ion current: 0.05 pA
·Repetition frequency: 8.2 kHz
·Raster mode: Unbunch
·Raster size: 50 μm×50 μm
·Measurement mode: Positive
·Neutralization electron gun: not used
·Measurement time: 360 seconds

·Pixel size: 256×256
·Sample pretreatment: accelerating voltage 10 kV, current 17.2 nA, raster size 400×400 μm, sputtering time 48 seconds

In each of 256×256 pixels corresponding to an 50 μm×50 μm observation region, the count number of fragment ions having a mass number corresponding to the molecular weight of anions (for example, bis(trifluoromethanesulfonyl) imide anions ($TFSI^-$), a molecular weight of 280) of the ionic liquid observed under the above measurement conditions was taken as the brightness of each pixel and the brightness was then converted into 256 gradations to obtain a monochrome image.
The obtained monochrome image was smoothed and binarized using image processing software (ImageJ) to separate the matrix (a brightness of 255) and the domain (a brightness of 0). As a filter for smoothing, a median filter with a kernel size of 3×3 was used. The threshold value for binarization was determined based on the fuzzy binarization method of Huang described in Non Patent Literature 2 from the brightness distribution of the monochrome image.
For noise processing on the obtained binarized image, when the number of pixels in a domain with a brightness of 0 was 0.05% or less of the total number of pixels, the domain was thought to be caused by noise and was overwritten with a brightness of 255. The contour of the matrix (a brightness of 255) was extracted from the noise-removed binarized image obtained in this manner, the region surrounded by the obtained contour was set as a selection range, and the average brightness of the monochrome image in the range was calculated, and this was defined as the concentration D of the ionic liquid comprised in the matrix. Next, the average brightness of the entire monochrome image was calculated, and this was defined as the concentration C of the ionic liquid per observation region.
Next, the following processing was performed on each domain (a brightness of 0) of the noise-removed binarized image. The domain was selected as a range (a1), and enlarged 1.2 times with the geometric center c1 fixed (a2). A set difference a3 between the range a2 after enlargement and the range a1 before enlargement was taken, and a range selection of the vicinity region of the domain was obtained. The union A3 of the vicinity regions of the domains obtained for each domain was taken, the average brightness of the monochrome image in the range was calculated, and this was defined as defined as the concentration D3 of the ionic liquid in the vicinity of the interface of the domain in the matrix.
Here, when a3 included a domain, it was not included in the calculation of A3. That is, A3 was a region in the matrix.
When D/C and D3/D were measured, the arithmetic average value of three observation regions was used.

[Evaluation 5: Evaluation of Relative Dielectric Constant]

A dielectric sample was cut to 1.5 cm× 1.5 cm, and inserted into a four-terminal sample holder (SH2-Z type, commercially available from Toyo Corporation). Using an impedance analyzer (1260A, commercially available from Solartron), and a dielectric interface (1296A, commercially available from Solartron), sweeping was performed at room temperature with an AC voltage of 0.1 Vpp and a frequency of 0.01 Hz to 1 MHz, and a relative dielectric constant ε' at 100 Hz was measured. The arithmetic average value of three samples was used.

[Evaluation 6: Evaluation of Dielectric Breakdown Strength]

A dielectric test piece was prepared in the same procedure as described in Evaluation 8 to be described below, and a DC voltage was applied in steps of 1 kV in a range of 1 kV/mm to 20 kV/mm under conditions at room temperature using a withstand voltage tester (GPT-9903A, commercially available from Texio Technology Corporation). The application pattern included a RAMP period for 10 seconds and then a set voltage held for 30 seconds. When a current exceeding 5 mA was detected during this application pattern in an ARC mode OFF state, it was determined that the dielectric breakdown occurred at the electric field intensity, and the electric field intensity in this step was determined as the dielectric breakdown strength. The arithmetic average value of three samples was used.

[Evaluation 7: Evaluation of Young's Modulus]

Using a viscoelasticity measurement device (product name: Rheogel-E4000, commercially available from UBM), measurement was performed as follows. A 5 mm×30 mm dielectric test piece formed by a punching cutter was set in a tensile tester chuck, a sinusoidal strain with an amplitude of 1 mm was applied at room temperature, and the complex elastic modulus at 1 to 200 Hz was obtained. Of this, the real part component at 1 Hz was determined as the Young's modulus of the test piece. The arithmetic average value of three samples was used.

[Evaluation 8: Evaluation of Hysteresis Loss]

Using a viscoelasticity measurement device (product name: Rheogel-E4000, commercially available from UBM), measurement was performed as follows. A 5 mm×30 mm dielectric test piece formed by a punching cutter was set in a tensile tester chuck, and a stress-strain curve was obtained under conditions of an amount of displacement of 9 mm, a displacement speed of 0.275 mm/sec, and a number of reciprocating displacements of 5 at room temperature. Calculation was performed using the following formula from the obtained stress-strain curve. The arithmetic average value of three samples was used.

Hysteresis loss [%]=(1-(elasticity deformation workload/total deformation workload))×100

[Evaluation 9: Evaluation of Amount of Strain When Electric Field is Applied]

A dielectric sample was cut to 1.5 cm×4.5 cm using a commercially available cutter. The surface of the cut sample was modified using an excimer lamp light source (EX-mini L12530, commercially available from Hamamatsu Photonics K.K.), a conductive coating agent (Denatron SPS-801, commercially available from Nagase ChemteX Corporation) was then applied to a 1.5 cm×4.5 cm surface (both surfaces) to a thickness of 100 μm in a size of 0.8 cm×4.1 cm, the sample was then left in an environment at 100°C for 5 minutes, and the solvent comprised in the conductive coating agent was evaporated to form an electrode.

Next, the obtained dielectric with electrodes was suspended with one side of 1.5 cm fixed and the other side of 4.5 cm in a vertical direction. A withstand voltage tester (GPT-9903A, commercially available from Texio Technology Corporation) was used as a voltage source, and an electric field of 8 kV/mm was applied between the electrodes facing each other. In this case, the amount of displacement Δd of the 1.5 cm side facing the fixed side with respect to the normal direction of the 1.5 cm×4.5 cm surface before the electric field was applied was obtained using a small laser displacement sensor (HL-G108-S-J, commercially available from Panasonic Corporation). The amount of strain was calculated from the obtained Δd using the following formula.

$$\text{Amount of strain } [\%] = (\Delta d[\text{cm}]/4.5[\text{cm}]) \times 100$$

[Evaluations 10 and 11: Evaluation of Arithmetic Average Value (average diameter) of Equivalent Circle Diameters of Domain, and Area Ratio]

Each of the three viscoelastic images obtained in Evaluation 2 was converted into a 256-gradation grayscale image using image processing software (product name: ImageProPlus, commercially available from Media Cybernetics, Inc.), and then binarized to obtain a binarized image for analysis. The threshold value for binarization was determined from the monochrome image brightness distribution based on the Otsu's algorithm described in Non Patent Literature 3.

From the obtained binarized image, the area of the domain was calculated using the count function of the image processing software. However, among the domains determined by the count function, domains with a cross-sectional area of less than 0.05 area% in the observation region of 50 μm squares were considered as noise and removed from data. The area corresponding to the matrix was calculated by subtracting the obtained area from the total area of the observation region. The area ratio (matrix/domain) was calculated from these areas.

In addition, the binarized image was subjected to morphological transformation, and a contour corresponding to the domain-matrix interface was extracted. In the morphological transformation, an image was generated by expanding the binarized image with a kernel size of 3×3, an image was generated by shrinking the binarized image with the same kernel size, and the difference between them was obtained as a transformed image. A circle was detected using a Hough transform from the obtained contour, and the equivalent circle diameter of the domain was calculated from the diameter of the detected circle. The arithmetic average value of all domains in the observation region was used.

[Evaluations 12 and 13: Measurement of Circularity and Number of Domains]

From the noise-removed binarized images obtained in Evaluations 10 and 11, the circularity of the domain was calculated using the count function of the image software. Then, among the domains in the observation region, the number of domains with a circularity of 0.60 to 0.95 was counted, and the ratio (%) of this number to the total number of domains in the observation region was calculated.

[Evaluation 14: tanδ Peak Temperature due to Glass Transition]

Using a viscoelasticity measurement device (product name: Physica MCR302, commercially available from Anton Paar), measurement was performed as follows. A test piece with a thickness of 2 mm and a width of 5 mm formed by a punching cutter was set, the viscoelasticity was measured in a torsion mode (twisting) within a length of 20 mm at a heating rate of 2°C/min from -85°C to 20°C at a frequency of 1 Hz, and a temperature-tanδ curve was obtained.

[Example 1]

<Preparation of Urethane Prepolymer UP1-1>

31.2 parts by mass of the polyol A-1, 0.3 parts by mass of the polyisocyanate B-1, and 1,000 ppm of the curing catalyst C-1 were uniformly mixed, and the mixture was heated at a temperature of 100°C for 24 hours to synthesize a polyol having an isocyanate group at the terminal (first urethane prepolymer). 58.0 parts by mass of the polyol A-2 was mixed into the polyol, and the mixture was heated at a temperature of 100°C for 4 hours to manufacture a urethane prepolymer UP1-1 (second urethane prepolymer) (step (i) and step (ii)).

Here, in the following examples and comparative examples, the amount of the curing catalyst C-1 is expressed in ppm by mass based on the mass of all materials used in the dielectric.

<Synthesis of Dielectric No. 1>

89.5 parts by mass of the urethane prepolymer UP1-1, and 2.0 parts by mass of the ionic liquid E-1 were mixed, the mixture was stirred until it became homogeneous using a self-rotating vacuum stirring and defoaming mixer (product name: V-mini300, commercially available from EME Corporation) under conditions of an orbital speed of 1,600 rpm to obtain a urethane prepolymer UP1-2 comprising the ionic liquid (step (iii)).

91.5 parts by mass of UP1-2, 3.2 parts by mass of the polyisocyanate B-1, and 5.3 parts by mass of the polyisocyanate B-2 were mixed, and the mixture was stirred until it became homogeneous using a self-rotating vacuum stirring and defoaming mixer (product name: V-mini300, commercially available from EME Corporation) under conditions of an orbital speed of 1,600 rpm for about 1 to 2 minutes to obtain a dielectric forming mixture.

Next, the dielectric forming mixture was inserted between release films spaced at 100 μm, and cured by heating at a temperature of 130°C for 2 hours (step (iv)). Next, the cured product was peeled off from the film, and post-cured at a temperature of 80°C for 3 days to obtain a sheet-shaped dielectric No. 1 with a thickness of 100 μm.

[Example 2]

<Preparation of Urethane Prepolymer UP2-1>

31.3 parts by mass of the polyol A-1,
0.2 parts by mass of the polyisocyanate B-1, and,
1,000 ppm of the curing catalyst C-1 were uniformly mixed, and the mixture was heated at a temperature of 100°C for 24 hours to synthesize a polyol having an isocyanate group at the terminal.
58.1 parts by mass of the polyol A-4 was mixed into this, and the mixture was heated at a temperature of 100°C for 4 hours to manufacture a urethane prepolymer UP2-1.

<Synthesis of Dielectric No. 2>

89.6 parts by mass of the urethane prepolymer UP2-1, and,
2.0 parts by mass of the ionic liquid E-2 were mixed, the mixture was stirred until it became homogeneous using a self-rotating vacuum stirring and defoaming mixer (product name: V-mini300, commercially available from EME Corporation) under conditions of an orbital speed of 1,600 rpm to obtain a urethane prepolymer UP2-2 comprising the ionic liquid.
91.6 parts by mass of UP2-2,
3.0 parts by mass of the polyisocyanate B-1, and,
5.4 parts by mass of the polyisocyanate B-2 were mixed, and the mixture was stirred until it became homogeneous

using a self-rotating vacuum stirring and defoaming mixer (product name: V-mini300, commercially available from EME Corporation) under conditions of an orbital speed of 1,600 rpm for about 1 to 2 minutes to obtain a dielectric forming mixture.

Next, a dielectric No. 2 was obtained in the same manner as in Example 1 except that this dielectric forming mixture was used.

[Example 3]

<Preparation of Urethane Prepolymer UP3-1>

31.2 parts by mass of the polyol A-1,
0.5 parts by mass of the polyisocyanate B-1, and,
1,000 ppm of the curing catalyst C-1 were uniformly mixed, and the mixture was heated at a temperature of 100°C for 24 hours to synthesize a polyol having an isocyanate group at the terminal.
58.7 parts by mass of the polyol A-4 was mixed into this, and the mixture was heated at a temperature of 100°C for 4 hours to manufacture a urethane prepolymer UP3-1.

<Synthesis of Dielectric No. 3>

91.4 parts by mass of the urethane prepolymer UP3-1, and,
1.0 parts by mass of the ionic liquid E-3 were mixed, the mixture was stirred until it became homogeneous using a self-rotating vacuum stirring and defoaming mixer (product name: V-mini300, commercially available from EME Corporation) under conditions of an orbital speed of 1,600 rpm to obtain a urethane prepolymer UP3-2 comprising the ionic liquid.
92.4 parts by mass of UP3-2,
2.2 parts by mass of the polyisocyanate B-1, and,
5.4 parts by mass of the polyisocyanate B-2 were mixed, and the mixture was stirred until it became homogeneous using a self-rotating vacuum stirring and defoaming mixer (product name: V-mini300, commercially available from EME Corporation) under conditions of an orbital speed of 1,600 rpm for about 1 to 2 minutes to obtain a dielectric forming mixture. Next, a dielectric No. 3 was obtained in the same manner as in Example 1 except that this dielectric forming mixture was used.

[Example 4]

<Preparation of Urethane Prepolymer UP4-1>

31.4 parts by mass of the polyol A-1,
0.5 parts by mass of the polyisocyanate B-1, and,
1,000 ppm of the curing catalyst C-1 were uniformly mixed, and the mixture was heated at a temperature of 100°C for 24 hours to synthesize a polyol having an isocyanate group at the terminal.
58.3 parts by mass of the polyol A-4 was mixed into this, and the mixture was heated at a temperature of 100°C for 4 hours to manufacture a urethane prepolymer UP4-1.

<Synthesis of Dielectric No. 4>

90.2 parts by mass of the urethane prepolymer UP4-1, and,
1.8 parts by mass of the ionic liquid E-4 were mixed, the mixture was stirred until it became homogeneous using a self-rotating vacuum stirring and defoaming mixer (product name: V-mini300, commercially available from EME Corporation) under conditions of an orbital speed of 1,600 rpm to obtain a urethane prepolymer UP4-2 comprising the ionic

liquid.
92.0 parts by mass of UP4-2,
2.6 parts by mass of the polyisocyanate B-1, and,
5.4 parts by mass of the polyisocyanate B-2 were mixed, and the mixture was stirred until it became homogeneous using a self-rotating vacuum stirring and defoaming mixer (product name: V-mini300, commercially available from EME Corporation) under conditions of an orbital speed of 1,600 rpm for about 1 to 2 minutes to obtain a dielectric forming mixture. Next, a dielectric No. 4 was obtained in the same manner as in Example 1 except that this dielectric forming mixture was used.

[Example 5]

<Preparation of Urethane Prepolymer UP5-1>

30.4 parts by mass of the polyol A-2,
2.8 parts by mass of the polyisocyanate B-1, and,
1,000 ppm of the curing catalyst C-1 were uniformly mixed, and the mixture was heated at a temperature of 100°C for 24 hours to synthesize a polyol having an isocyanate group at the terminal.
56.6 parts by mass of the polyol A-4 was mixed into this, and the mixture was heated at a temperature of 100°C for 4 hours to manufacture a urethane prepolymer UP5-1.

<Synthesis of Dielectric No. 5>

89.8 parts by mass of the urethane prepolymer UP5-1, and,
2.0 parts by mass of the ionic liquid E-1 were mixed, the mixture was stirred until it became homogeneous using a self-rotating vacuum stirring and defoaming mixer (product name: V-mini300, commercially available from EME Corporation) under conditions of an orbital speed of 1,600 rpm to obtain a urethane prepolymer UP5-2 comprising the ionic liquid.
91.8 parts by mass of UP5-2,
2.8 parts by mass of the polyisocyanate B-1, and,
5.4 parts by mass of the polyisocyanate B-2 were mixed, and the mixture was stirred until it became homogeneous using a self-rotating vacuum stirring and defoaming mixer (product name: V-mini300, commercially available from EME Corporation) under conditions of an orbital speed of 1,600 rpm for about 1 to 2 minutes to obtain a dielectric forming mixture. Next, a dielectric No. 5 was obtained in the same manner as in Example 1 except that this dielectric forming mixture was used.

[Example 6]

<Preparation of Urethane Prepolymer UP6-1>

31.0 parts by mass of the polyol A-3,
1.4 parts by mass of the polyisocyanate B-1, and,
1,000 ppm of the curing catalyst C-1 were uniformly mixed, and the mixture was heated at a temperature of 100°C for 24 hours to synthesize a polyol having an isocyanate group at the terminal.
57.4 parts by mass of the polyol A-4 was mixed into this, and the mixture was heated at a temperature of 100°C for 4 hours to manufacture a urethane prepolymer UP6-1.

<Synthesis of Dielectric No. 6>

89.8 parts by mass of the urethane prepolymer UP6-1, and,
2.0 parts by mass of the ionic liquid E-1 were mixed, the mixture was stirred until it became homogeneous using a self-rotating vacuum stirring and defoaming mixer (product name: V-mini300, commercially available from EME Corporation) under conditions of an orbital speed of 1,600 rpm to obtain a urethane prepolymer UP6-2 comprising the ionic liquid.

91.8 parts by mass of UP6-2,

2.8 parts by mass of the polyisocyanate B-1, and,

5.4 parts by mass of the polyisocyanate B-2 were mixed, and the mixture was stirred until it became homogeneous using a self-rotating vacuum stirring and defoaming mixer (product name: V-mini300, commercially available from EME Corporation) under conditions of an orbital speed of 1,600 rpm for about 1 to 2 minutes to obtain a dielectric forming mixture. Next, a dielectric No. 6 was obtained in the same manner as in Example 1 except that this dielectric forming mixture was used.

[Example 7]

<Preparation of Urethane Prepolymer UP7-1>

31.1 parts by mass of the polyol A-1,

0.5 parts by mass of the polyisocyanate B-1, and,

1,000 ppm of the curing catalyst C-1 were uniformly mixed, and the mixture was heated at a temperature of 100°C for 24 hours to synthesize a polyol having an isocyanate group at the terminal.

58.0 parts by mass of the polyol A-5 was mixed into this, and the mixture was heated at a temperature of 100°C for 4 hours to manufacture a urethane prepolymer UP7-1.

<Synthesis of Dielectric No. 7>

89.6 parts by mass of the urethane prepolymer UP7-1, and,

2.0 parts by mass of the ionic liquid E-1 were mixed, the mixture was stirred until it became homogeneous using a self-rotating vacuum stirring and defoaming mixer (product name: V-mini300, commercially available from EME Corporation) under conditions of an orbital speed of 1,600 rpm to obtain a urethane prepolymer UP7-2 comprising the ionic liquid.

91.6 parts by mass of UP7-2,

3.0 parts by mass of the polyisocyanate B-1, and,

5.4 parts by mass of the polyisocyanate B-2 were mixed, and the mixture was stirred until it became homogeneous using a self-rotating vacuum stirring and defoaming mixer (product name: V-mini300, commercially available from EME Corporation) under conditions of an orbital speed of 1,600 rpm for about 1 to 2 minutes to obtain a dielectric forming mixture. Next, a dielectric No. 7 was obtained in the same manner as in Example 1 except that this dielectric forming mixture was used.

[Example 8]

<Preparation of Urethane Prepolymer UP8-1>

40.5 parts by mass of the polyol A-1,

0.6 parts by mass of the polyisocyanate B-1, and,

1,000 ppm of the curing catalyst C-1 were uniformly mixed, and the mixture was heated at a temperature of 100°C for 24 hours to synthesize a polyol having an isocyanate group at the terminal.

49.4 parts by mass of the polyol A-4 was mixed into this, and the mixture was heated at a temperature of 100°C for 4 hours to manufacture a urethane prepolymer UP8-1.

<Synthesis of Dielectric No. 8>

90.5 parts by mass of the urethane prepolymer UP8-1, and,
2.0 parts by mass of the ionic liquid E-1 were mixed, the mixture was stirred until it became homogeneous using a self-rotating vacuum stirring and defoaming mixer (product name: V-mini300, commercially available from EME Corporation) under conditions of an orbital speed of 1,600 rpm to obtain a urethane prepolymer UP8-2 comprising the ionic liquid.
92.5 parts by mass of UP8-2,
2.1 parts by mass of the polyisocyanate B-1, and,
5.4 parts by mass of the polyisocyanate B-2 were mixed, and the mixture was stirred until it became homogeneous using a self-rotating vacuum stirring and defoaming mixer (product name: V-mini300, commercially available from EME Corporation) under conditions of an orbital speed of 1,600 rpm for about 1 to 2 minutes to obtain a dielectric forming mixture. Next, a dielectric No. 8 was obtained in the same manner as in Example 1 except that this dielectric forming mixture was used.

[Example 9]

<Preparation of Urethane Prepolymer UP9-1>

40.1 parts by mass of the polyol A-1,
0.7 parts by mass of the polyisocyanate B-1, and,
1,000 ppm of the curing catalyst C-1 were uniformly mixed, and the mixture was heated at a temperature of 100°C for 24 hours to synthesize a polyol having an isocyanate group at the terminal. 50.4 parts by mass of the polyol A-4 was mixed into this, and the mixture was heated at a temperature of 100°C for 4 hours to manufacture a urethane prepolymer UP9-1.

<Synthesis of Dielectric No. 9>

91.2 parts by mass of the urethane prepolymer UP9-1, and,
2.0 parts by mass of the ionic liquid E-3 were mixed, the mixture was stirred until it became homogeneous using a self-rotating vacuum stirring and defoaming mixer (product name: V-mini300, commercially available from EME Corporation) under conditions of an orbital speed of 1,600 rpm to obtain a urethane prepolymer UP9-2 comprising the ionic liquid.
93.2 parts by mass of UP9-2,
1.4 parts by mass of the polyisocyanate B-1, and,
5.4 parts by mass of the polyisocyanate B-2 were mixed, and the mixture was stirred until it became homogeneous using a self-rotating vacuum stirring and defoaming mixer (product name: V-mini300, commercially available from EME Corporation) under conditions of an orbital speed of 1,600 rpm for about 1 to 2 minutes to obtain a dielectric forming mixture. Next, a dielectric No. 9 was obtained in the same manner as in Example 1 except that this dielectric forming mixture was used.

[Comparative Example 1]

89.4 parts by mass of the polyol A-4,
5.2 parts by mass of the polyisocyanate B-1,
5.4 parts by mass of the polyisocyanate B-2, and,
1,000 ppm of the curing catalyst C-1, were mixed, and the mixture was stirred until it became homogeneous using a self-rotating vacuum stirring and defoaming mixer under conditions of an orbital speed of 1,600 rpm for 2 minutes to obtain a dielectric forming mixture. Next, a polyurethane elastomer No. C1 was obtained in the same manner as in Example 1 except that this dielectric forming mixture was used.

[Comparative Example 2]

97.2 parts by mass of the polyol A-1,
2.8 parts by mass of the polyisocyanate B-2, and,
250 ppm of the curing catalyst C-2, were mixed, and the mixture was stirred until it became homogeneous using a self-rotating vacuum stirring and defoaming mixer under conditions of an orbital speed of 1,600 rpm for 2 minutes to obtain a dielectric forming mixture. Next, a polyurethane elastomer No. C2 was obtained in the same manner as in Example 1 except that this dielectric forming mixture was used.

[Comparative Example 3]

87.1 parts by mass of the polyol A-4, and,
1.8 parts by mass of the ionic liquid E-1, were mixed, and the mixture was stirred until it became homogeneous for 10 minutes using a self-rotating vacuum stirring and defoaming mixer under conditions of an orbital speed of 1,600 rpm to obtain a mixture comprising the ionic liquid.
To 88.9 parts by mass of the obtained mixture,
5.7 parts by mass of the polyisocyanate B-1,
5.4 parts by mass of the polyisocyanate B-2, and,
1,000 ppm of the curing catalyst C-1 were mixed, and the mixture was stirred until it became homogeneous using a self-rotating vacuum stirring and defoaming mixer under conditions of an orbital speed of 1,600 rpm for 2 minutes to obtain a dielectric forming mixture. Next, a polyurethane elastomer No. C3 was obtained in the same manner as in Example 1 except that this dielectric forming mixture was used.

[Comparative Example 4]

94.1 parts by mass of the polyol A-1, and,
2.0 parts by mass of the ionic liquid E-1, were mixed, and the mixture was stirred until it became homogeneous for 10 minutes using a self-rotating vacuum stirring and defoaming mixer under conditions of an orbital speed of 1,600 rpm to obtain a mixture comprising the ionic liquid.
To 96.1 parts by mass of the obtained mixture,
3.9 parts by mass of the polyisocyanate B-2, and,
250 ppm of the curing catalyst C-2 were mixed, and the mixture was stirred until it became homogeneous using a self-rotating vacuum stirring and defoaming mixer under conditions of an orbital speed of 1,600 rpm for 2 minutes to obtain a dielectric forming mixture. Next, a polyurethane elastomer No. C4 was obtained in the same manner as in Example 1 except that this dielectric forming mixture was used.

The results of Evaluations 1 to 14 for Examples 1 to 9 and Comparative Examples 1 to 4 are shown in Table 1 to Table 2.

<Structure of Dielectric>

Regarding the results of Evaluation 1, clear phase separation between the matrix and the domain was observed in the dielectrics No. 1 to 9 according to Examples 1 to 9. In addition, it was confirmed that the matrix comprised polyurethane comprising a structure derived from polycarbonate (second structure), and the domain comprised a structure derived from polyether (first structure). In addition, regarding the results of Evaluation 2, in the dielectrics No. 1 to 9, the relationship between the parameter A indicating the viscoelasticity term of the domain and the parameter B indicating the viscoelasticity term of the matrix satisfied $A<B$.

Regarding the results of Evaluation 3, Fig. 2 shows a visualized image of the distribution of the ionic liquid in the cross section of the polyurethane elastomer No. 1 obtained using time-of-flight secondary ion mass spectrometry (TOF-SIMS). Based on the results, a clear matrix-domain phase separation structure was confirmed, and additionally, the ionic liquid was predominantly distributed in the matrix.

In addition, it was confirmed that, in the dielectrics according to Examples 1 to 9, the relationship between the concentration C of the ionic liquid per unit cross-sectional area and the concentration D of the ionic liquid comprised in the matrix per unit cross-sectional area satisfied $D/C>1.0$.

In addition, in the dielectrics according to Examples 1 to 9, since the concentration D3 of the ionic liquid in the vicinity region of the domain and the concentration D of the ionic liquid comprised in the matrix satisfied $D3/D>1.0$,

predominant distribution of the ionic liquid on the side of the matrix in the vicinity of the interface between the matrix and the domain was clear.

Regarding the results of Evaluation 14, Fig. 3 shows representative temperature-tanδ curves obtained by viscoelasticity measurement (Examples 1 and 2 and Comparative Example 1). As shown in Fig. 3, in Example 1 and Example 2, two tanδ peak temperatures (glass transition temperatures) were confirmed in a range of -80 to 10°C, and only one peak temperature was confirmed in Comparative Example 1.

In addition, in Examples 3 to 9, two glass transition temperatures were confirmed, as in Examples 1 and 2.

In addition, in the dielectrics No. 1 to 9 according to Examples 1 to 9, the appearance of the dielectric was opaque. On the other hand, the dielectrics No. C1 to C4 according to Comparative Examples 1 to 4 had high transparency.

The tanδ peak temperatures observed in the dielectric No. 1 and the dielectric No. 2 according to Examples 1 and 2 were -67°C and -18°C, which were glass transition temperatures corresponding to the polyether polyurethane derived from the raw material A-1 (polypropylene glycol) and the polycarbonate polyurethane derived from the raw material A-4 (polycarbonate polyol) (refer to Comparative Example 1). That is, it can be clearly understood that, in the dielectrics No. 1 and 2 obtained in Examples 1 and 2, polyurethane comprising polycarbonate and polyurethane comprising polyether were almost incompatible with each other, and were present with clear phase separation.

In addition, similarly, in Examples 3 to 9, two glass transition temperatures corresponding to the glass transition temperatures of the polyurethane comprising polycarbonate and the polyurethane comprising polyether were confirmed.

On the other hand, in the dielectrics No. C1 to C4 obtained in Comparative Examples 1 to 4, no phase separation structure was confirmed in the cross-section image observation in Evaluations 1 to 3, and 9 to 12. In addition, as described above, tanδ observed in Comparative Example 1 showed a single peak, and having no phase separation structure was confirmed from this result. This tendency was also observed in Comparative Examples 2 to 4.

<Evaluation Results of Dielectric>

The dielectrics No. 1 to 9 according to Examples 1 to 9 had a lower Young's modulus and better low hysteresis loss properties than that of the single polycarbonate polyurethane No. C1 obtained in Comparative Example 1. In addition, a significant increase in the relative dielectric constant was observed, and a clear difference was observed in the amount of strain when the electric field was applied.

In addition, in Comparative Example 3, which was obtained by adding an ionic liquid to Comparative Example 1, no increase in dielectric constant was observed as in Examples 1 to 9. In addition, all of Examples 1 to 9 had the resistance to dielectric breakdown equal to or higher than that of Comparative Example 3.

The single polyether polyurethane No. C2 obtained in Comparative Example 2 had a low Young's modulus, but had a high hysteresis loss, and did not achieve a high-level increase in relative dielectric constant as in Examples 1 and 2.

In Comparative Example 4, which was obtained by adding an ionic liquid to Comparative Example 2, a significant increase in the relative dielectric constant was observed, but the same level of low hysteresis loss as in Examples 1 to 9 could not be achieved.

It was confirmed that all of Examples 1 to 9 had sufficient dielectric breakdown strength, but particularly in Examples 1 and 2 and Examples 4 to 8 using the ionic liquid having a reactive functional group that reacts with an isocyanate group, a favorable dielectric breakdown strength exceeding 20 kV/mm was obtained.

All of Examples 1 to 9 had an excellent relative dielectric constant, but particularly, in Examples 1 to 5 and Examples 7 to 9 in which $R^1$ is an alkylene group having a branched structure and having 3 to 5 carbon atoms in Formula (1), a favorable relative dielectric constant was obtained.

Based on the above evaluation results, it can be clearly understood that the dielectric according to the present disclosure has excellent dielectric properties and has low hysteresis and loss and flexibility in combination, and is suitable as a dielectric for a transducer and the like.

[Table 1]

| | | Evaluation 1 | Evaluation 2 | Evaluation 3 | Evaluation 4 | Evaluation 5 | Evaluation 6 | Evaluation 7 | Evaluation 8 | Evaluation 9 |
|---|---|---|---|---|---|---|---|---|---|---|
| | | Confirmation and analysis of matrix phase (M) and domain phase (D) | A/B | D/C | D3/D | Relative dielectric constant | Dielectric breakdown strength (kV/mm) | Young's modulus (MPa) | Hysteresis loss (%) | Amount of strain when electric field is applied (%) |
| Example | 1 | ・Clear phase separation between M and D<br>・M: structure derived from polycarbonate<br>・D: structure derived from polyether | 40 / 250 | 1.4 | 1.05 | 18.3 | 20< | 2 | 4 | 9 |
| | 2 | ・Clear phase separation between M and D<br>・M: structure derived from polycarbonate<br>・D: structure derived from polyether | 40 / 250 | 1.5 | 1.04 | 16.5 | 20< | 1.9 | 3 | 9.5 |
| | 3 | ・Clear phase separation between M and D<br>・M: structure derived from polycarbonate<br>・D: structure derived from polyether | 40 / 250 | 1.3 | 1.08 | 26.0 | 18 | 2.2 | 7 | 14.1 |
| | 4 | ・Clear phase separation between M and D<br>・M: structure derived from polycarbonate<br>・D: structure derived from polyether | 40 / 250 | 1.5 | 1.04 | 16.8 | 20< | 2.1 | 5 | 6.8 |
| | 5 | ・Clear phase separation between M and D<br>・M: structure derived from polycarbonate<br>・D: structure derived from polyether | 50 / 240 | 1.3 | 1.03 | 18.6 | 20< | 2.4 | 3 | 10.4 |
| | 6 | ・Clear phase separation between M and D<br>・M: structure derived from polycarbonate<br>・D: structure derived from polyether | 50 / 250 | 1.4 | 1.04 | 11.4 | 20< | 2.4 | 7 | 5.3 |
| | 7 | ・Clear phase separation between M and D<br>・M: structure derived from polycarbonate<br>・D: structure derived from polyether | 40 / 260 | 1.4 | 1.05 | 14.3 | 20< | 2.2 | 4 | 8.1 |
| | 8 | ・Clear phase separation between M and D<br>・M: structure derived from polycarbonate<br>・D: structure derived from polyether | 40 / 250 | 1.3 | 1.03 | 26.7 | 20< | 1.5 | 4 | 12.6 |
| | 9 | ・Clear phase separation between M and D<br>・M: structure derived from polycarbonate<br>・D: structure derived from polyether | 40 / 250 | 1.4 | 1.02 | 40.4 | 16 | 1.5 | 7 | 15.7 |
| Comparative Example | 1 | - | - | - | - | 3.3 | 20< | 4 | 11 | 0.3 |
| | 2 | - | - | - | - | 5.9 | 20< | 0.4 | 27 | 0.8 |
| | 3 | - | - | - | - | 3.7 | 14 | 2.7 | 19 | 2.9 |
| | 4 | - | - | - | - | 15.9 | 8 | 0.56 | 19 | 21 |

[Table 2]

| | | Evaluation 10 | Evaluation 11 | Evaluation 12 | Evaluation 13 | Evaluation 14 |
|---|---|---|---|---|---|---|
| | | Average particle diameter of domain phase (μm) | Matrix phase/ domain phase area ratio (%) | Average circularity of domain phase | Number of domain phases with circularity 0.60 or more and 0.95 or less (%) | tan δ peak temperature (°C) (glass transition temperature) |
| Example | 1 | 10.3 | 61.5 / 38.5 | 82 | 90 | -67/-18 |
| | 2 | 9.7 | 61.7 / 38.3 | 84 | 90 | -67/-18 |
| | 3 | 2.5 | 61.5 / 38.5 | 86 | 91 | -67/-17 |
| | 4 | 5.6 | 61.9 / 38.1 | 82 | 92 | -68/-18 |
| | 5 | 14.8 | 60.9 / 39.1 | 83 | 90 | -52/-17 |
| | 6 | 7.7 | 61.0 / 39.0 | 79 | 85 | -62/-18 |
| | 7 | 8.8 | 62.1 / 37.9 | 88 | 92 | -66/-16 |
| | 8 | 5.4 | 51.0 / 49.0 | 81 | 91 | -65/-20 |
| | 9 | 6.2 | 52.6 / 47.4 | 85 | 90 | -66/-19 |
| Comparative Example | 1 | - | - | - | - | -19 |
| | 2 | - | - | - | - | -66 |
| | 3 | - | - | - | - | -18 |
| | 4 | - | - | - | - | -64 |

The present disclosure is not limited by the embodiments, and can be variously changed and modified without departing from the spirit and the scope of the present disclosure. Therefore, in order to make the scope of the present disclosure public, the following claims are appended.

The present application claims the priority based on Japanese Patent Application No. 2022-170649 filed on 25 October 2022 and Japanese Patent Application No. 2023-177083 filed on 12 October 2023, the entire contents of which are herein incorporated by reference.

## Claims

**1.** A dielectric,

wherein the dielectric comprises a polyurethane elastomer and an ionic liquid in the polyurethane elastomer,
the polyurethane elastomer comprises a matrix and a domain dispersed in the matrix, and
the domain comprises a first structure represented by following Formula (1):

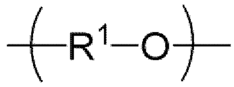 (1)

in Formula (1), $R^1$ represents an alkylene group having 3 to 6 carbon atoms.

**2.** The dielectric according to claim 1, wherein the ionic liquid is present in the matrix.

**3.** The dielectric according to claim 2, wherein the ionic liquid is predominantly distributed in the matrix in the vicinity of an interface between the matrix and the domain.

**4.** The dielectric according to any one of claims 1 to 3, wherein, in a viscoelastic image measured by a scanning probe microscope of a cross section of the dielectric in which the domain and the matrix are exposed, a relationship between a parameter A indicating a viscoelasticity term of the domain and a parameter B indicating a viscoelasticity term of the matrix satisfies $A<B$.

**5.** The dielectric according to claim 2 or 3, wherein, a concentration of the ionic liquid per 50 $\mu m \times 50$ $\mu m$ observation region, observed in the cross section in which the domain and the matrix of the dielectric are exposed, is defined as a concentration C, and a concentration of the ionic liquid comprised in the matrix in the observation region is defined as a concentration D, a value ratio D/C of the concentration D to the concentration C satisfies $D/C>1.0$.

**6.** The dielectric according to any one of claims 1 to 5, wherein an area ratio (matrix/domain) of the matrix to the domain observed in a 50 $\mu m \times 50$ $\mu m$ observation region in the cross section in which the domain and the matrix of the dielectric are exposed is 50.0/50.0 to 85.0/15.0.

**7.** The dielectric according to any one of claims 1 to 6, wherein the ionic liquid has a reactive functional group that reacts with an isocyanate group.

**8.** The dielectric according to any one of claims 1 to 7, wherein the ionic liquid is at least one ionic liquid selected from the group consisting of an ammonium-based ionic liquid and an imidazolium-based ionic liquid.

**9.** The dielectric according to any one of claims 1 to 8, wherein anions of the ionic liquid are at least one anion selected from the group consisting of $BF_4^-$, $PF_6^-$, $CF_3SO_3^-$ and $(CF_3SO_2)_2N^-$.

**10.** The dielectric according to any one of claims 1 to 9, wherein a content of the ionic liquid in the dielectric is 0.5 to 8.0 mass%.

**11.** The dielectric according to any one of claims 1 to 10,

wherein the matrix comprises a structure represented by following Formula (2):

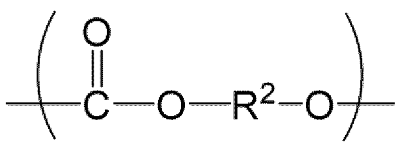 (2)

in Formula (2), $R^2$ represents an alkylene group having 3 to 12 carbon atoms.

**12.** The dielectric according to any one of claims 1 to 11, wherein the $R^1$ is an alkylene group having a branched structure with3 to 5 carbon atoms.

**13.** The dielectric according to claim 11,

wherein the $R^2$ is an alkylene group having 3 to 9 carbon atoms.

**14.** The dielectric according to any one of claims 1 to 13,
wherein an arithmetic average value of equivalent circle diameters of domains observed in the cross section in which the domain and the matrix of the dielectric are exposed is 0.2 to 30.0 μm.

**15.** The dielectric according to any one of claims 1 to 14,
wherein the relative dielectric constant of the dielectric is 10.0 or more.

**16.** The dielectric according to any one of claims 1 to 15,
wherein the Young's modulus of the dielectric is 2.5 MPa or less.

**17.** The dielectric according to any one of claims 1 to 16,
wherein a hysteresis loss of the dielectric is 10% or less.

**18.** The dielectric according to any one of claims 1 to 17,
wherein a dielectric breakdown strength of the dielectric is 15 kV/mm or more.

**19.** A method for manufacturing the dielectric according to any one of claims 1 to 18, comprising:

(i) a step of obtaining a second urethane prepolymer having at least two hydroxyl groups by reacting a first urethane prepolymer having at least one isocyanate group with a first polycarbonate polyol having at least two hydroxyl groups;
(ii) a step of obtaining a first dispersion by dispersing droplets comprising at least a part of the second urethane prepolymer in a second polycarbonate polyol;
(iii) a step of obtaining a second dispersion by dispersing the ionic liquid in the first dispersion; and
(iv) a step of preparing a dielectric forming mixture comprising the second dispersion and a polyisocyanate having at least two isocyanate groups, and then reacting the second urethane prepolymer, the second polycarbonate polyol, and the polyisocyanate in the dielectric forming mixture to form the dielectric.

**20.** A transducer, comprising:

at least two electrodes; and
the dielectric according to any one of claims 1 to 18 inserted between the electrodes.

**21.** The transducer according to claim 20, wherein the transducer is an actuator, a sensor, or a power generating element.

Fig.1

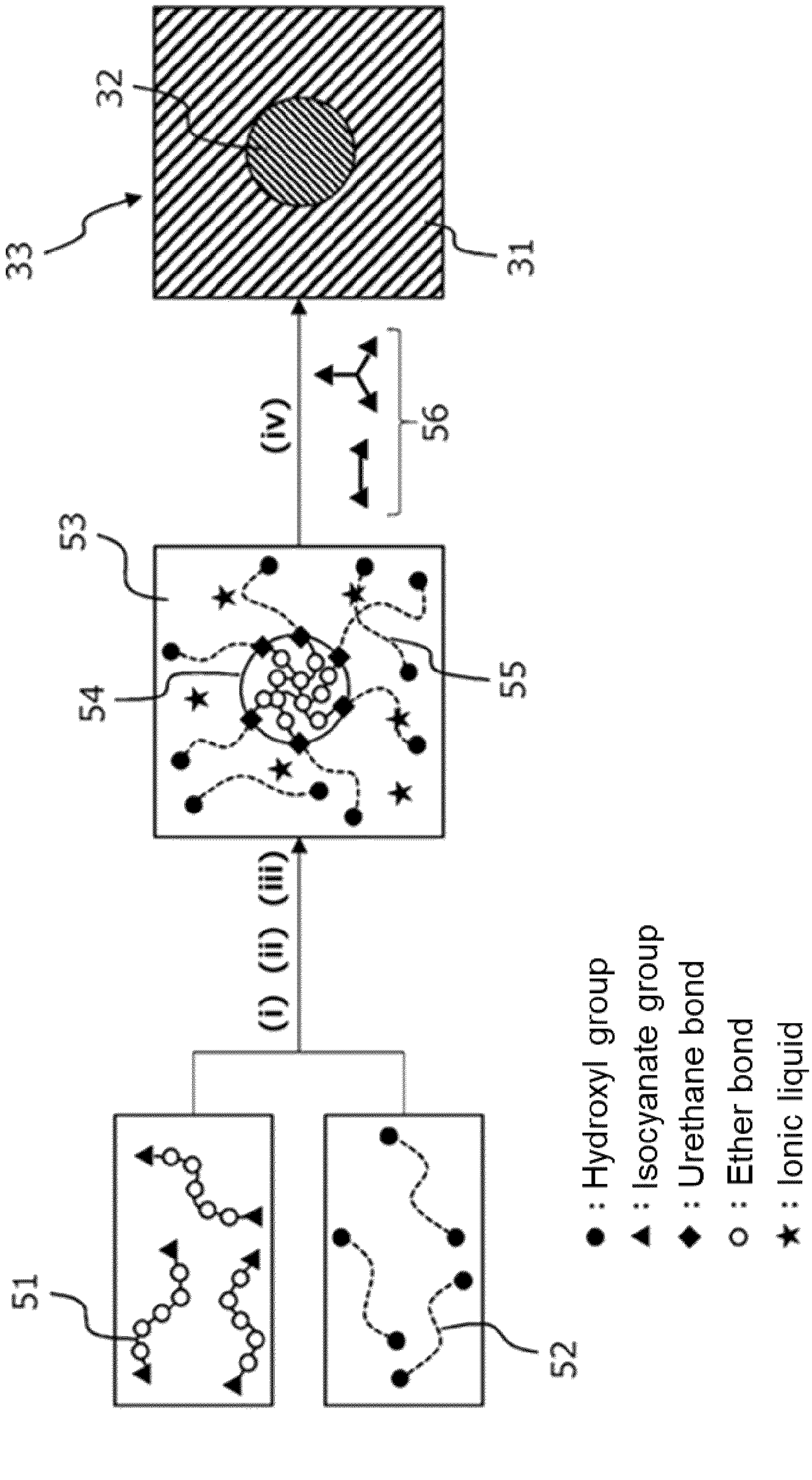
51
52
(i) (ii) (iii)
53
54
55
(iv)
56
33
32
31
●: Hydroxyl group
▲: Isocyanate group
◆: Urethane bond
○: Ether bond
★: Ionic liquid

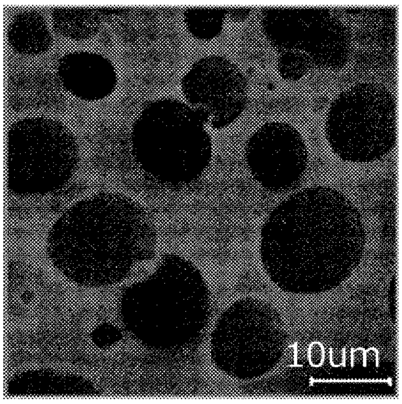


Fig.2

Fig.3

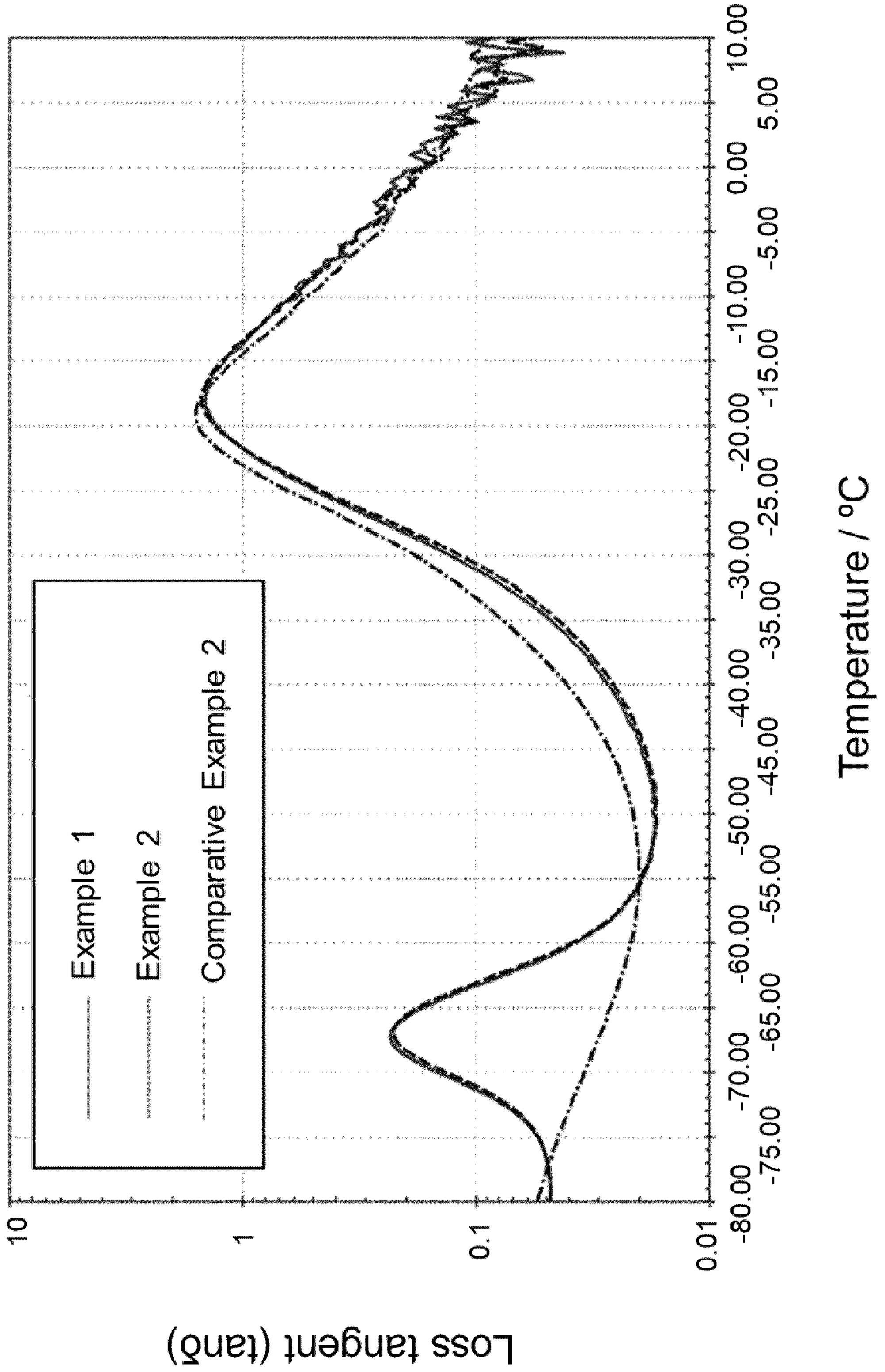
Example 1
Example 2
Comparative Example 2
Loss tangent (tanδ)
10
1
0.1
0.01
-80.00
-75.00
-70.00
-65.00
-60.00
-55.00
-50.00
-45.00
-40.00
-35.00
-30.00
-25.00
-20.00
-15.00
-10.00
-5.00
0.00
5.00
10.00
Temperature / °C

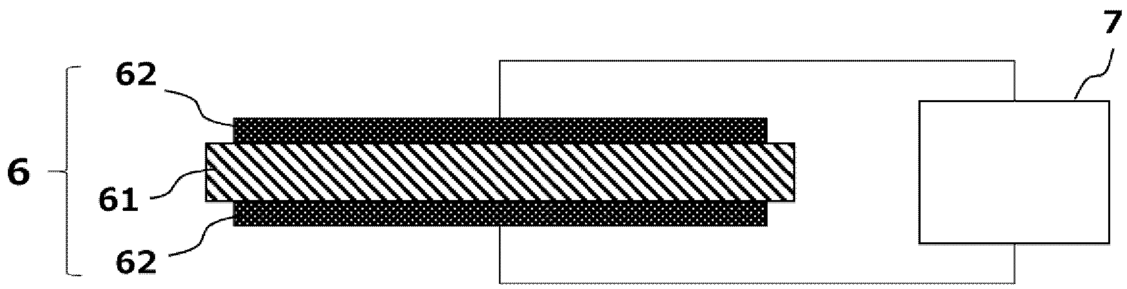


Fig.4

**INTERNATIONAL SEARCH REPORT**

International application No. **PCT/JP2023/038253**

**A. CLASSIFICATION OF SUBJECT MATTER**

***H10N 30/857***(2023.01)i; ***H10N 30/077***(2023.01)i; ***H10N 30/20***(2023.01)i; ***H10N 30/30***(2023.01)i
FI: H10N30/857; H10N30/20; H10N30/30; H10N30/077

According to International Patent Classification (IPC) or to both national classification and IPC

**B. FIELDS SEARCHED**

Minimum documentation searched (classification system followed by classification symbols)

H10N30/857; H10N30/077; H10N30/20; H10N30/30

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2022-44134 A (SHIN-ETSU POLYMER CO., LTD.) 17 March 2022 (2022-03-17) paragraphs [0012]-[0043], fig. 1-21 | 1-21 |
| A | JP 2018-41045 A (CANON INC.) 15 March 2018 (2018-03-15) paragraphs [0012]-[0080], fig. 1-6 | 1-21 |
| A | JP 2020-24404 A (CANON INC.) 13 February 2020 (2020-02-13) paragraphs [0015]-[0074], fig. 1-8 | 1-21 |
| A | US 2019/0036005 A1 (UNIVERSITY OF PITTSBURGH-OF THE COMMONWEALTH SYSTEM OF HIGHER EDUCATION) 31 January 2019 (2019-01-31) paragraphs [0023]-[0048], fig. 1-3 | 1-21 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **27 December 2023** | **16 January 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2023/038253**

| Patent document cited in search report | Publication date (day/month/year) | Patent family member(s) | Publication date (day/month/year) |
|---|---|---|---|
| JP 2022-44134 A | 17 March 2022 | (Family: none) | |
| JP 2018-41045 A | 15 March 2018 | (Family: none) | |
| JP 2020-24404 A | 13 February 2020 | US 2020/0041920 A1<br>paragraphs [0019]-[0094], fig. 1-8 | |
| US 2019/0036005 A1 | 31 January 2019 | WO 2017/136277 A1<br>p. 3, line 5 to column 6, line 31, fig. 1-3 | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2022069960 A
- JP 2021034207 A
- JP 2021113853 A
- JP 2022170649 A
- JP 2023177083 A


### Non-patent literature cited in the description


- *Sustainability*, 2021, vol. 13 (17), 9881
- **L.K. HUANG** ; **M.J.J. WANG**. Image thresholding by minimizing the measures of fuzziness. *Pattern recognition*, January 1995, vol. 28 (1), 41-51
- *IEEE Transactions on SYSTEMS, MAN, AND CYBERNETICS*, January 1979, vol. SMC-9 (1), 62-66